(19) **Europäisches Patentamt / European Patent Office / Office européen des brevets**

(11) **EP 4 047 072 B1**

(12) **EUROPÄISCHE PATENTSCHRIFT**

(45) Veröffentlichungstag und Bekanntmachung des Hinweises auf die Patenterteilung:
**13.12.2023   Patentblatt 2023/50**

(51) Internationale Patentklassifikation (IPC):
**C09K 11/68** (2006.01)   **C09K 11/67** (2006.01)
**H05B 33/14** (2006.01)

(21) Anmeldenummer: **22160482.0**

(22) Anmeldetag: **18.03.2019**

(52) Gemeinsame Patentklassifikation (CPC):
**H05B 33/14; C09K 11/671; C09K 11/681;**
**Y02B 20/00**

(54) **LICHTQUELLE MIT EINEM LUMINESZENZMATERIAL**

LIGHT SOURCE WITH LUMINESCENT MATERIAL

SOURCE LUMINEUSE DOTÉE D'UNE MATIÈRE LUMINESCENTE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.03.2018   EP 18162844**

(43) Veröffentlichungstag der Anmeldung:
**24.08.2022   Patentblatt 2022/34**

(62) Dokumentnummer(n) der früheren Anmeldung(en) nach Art. 76 EPÜ:
**19710700.6 / 3 768 800**

(73) Patentinhaber:
**LITEC-Vermögensverwaltungsgesellschaft mbH**
**17489 Greifswald (DE)**

(72) Erfinder:
  • **JANSEN, Thomas**
    **17491 Greifswald (DE)**
  • **JÜSTEL, Thomas**
    **58455 Witten (DE)**
  • **PETRY, Ralf**
    **64347 Griesheim (DE)**
  • **KÖHLER, Ingo**
    **64291 Darmstadt (DE)**
  • **SIEVERT, Katharina**
    **17498 Mesekenhagen (DE)**

(74) Vertreter: **Engel, Christoph Klaus**
**PATENTSCHUTZengel**
**Marktplatz 6**
**98527 Suhl (DE)**

(56) Entgegenhaltungen:
**CN-A- 106 800 930     CN-A- 107 043 624**

  • **XIUTANG ZHANG ET AL: "Divalent Manganese Linked Tungsten-Molybdenum Polyoxometalates: Synthesis, Structure, and Magnetic Characteristics", CRYSTAL GROWTH & DESIGN., Bd. 7, Nr. 9, 8. August 2007 (2007-08-08), Seiten 1699-1705, XP055589246, US ISSN: 1528-7483, DOI: 10.1021/cg060723f**
  • **MEEHAE JANG ET AL: "Aqueous Crystallization of Manganese(II) Group 6 Metal Oxides", CHEMISTRY OF MATERIALS, Bd. 13, Nr. 2, 1. Februar 2001 (2001-02-01), Seiten 519-525, XP055589252, ISSN: 0897-4756, DOI: 10.1021/cm000754c**
  • **ALEXEJ MICHAILOVSKI ET AL: "Solvothermal Morphology Studies: Alkali and Alkaline Earth Molybdates", HELVETICA CHIMICA ACTA, Bd. 87, Nr. 5, 1. Mai 2004 (2004-05-01), Seiten 1029-1047, XP055589272, ISSN: 0018-019X, DOI: 10.1002/hlca.200490095**

**Beschreibung**

**Gegenstand der Erfindung**

Die vorliegende Erfindung betrifft eine Lichtquelle, die ein Lumineszenzmaterial oder eine strahlungskonvertierende Mischung mit diesem Lumineszenzmaterial umfasst. Bei dem Lumineszenzmaterial handelt es sich bevorzugt um ein Mn(IV)-aktiviertes Lumineszenzmaterial. Die Lichtquelle kann beispielsweise durch eine pc-LED (phosphor converted light emitting diodes) gebildet sein, welche insbesondere zur Erzeugung von warm-weißem Licht ausgebildet ist.

**Hintergrund der Erfindung**

Seit mehr als 100 Jahren werden anorganische Leuchtstoffe entwickelt, um emittierende Bildschirme, Röntgenverstärker und Strahlungs- bzw. Lichtquellen spektral so anzupassen, dass sie Anforderungen des jeweiligen Anwendungsgebietes möglichst optimal erfüllen und gleichzeitig möglichst wenig Energie verbrauchen. Dabei sind die Art der Anregung, d.h. die Natur der primären Strahlungsquelle, und das erforderliche Emissionsspektrum von entscheidender Bedeutung für die Auswahl der Wirtsgitter und der Aktivatoren.

Insbesondere für Fluoreszenzlichtquellen für die Allgemeinbeleuchtung, also Niederdruckentladungslampen und Leuchtdioden, werden ständig neue Leuchtstoffe entwickelt, um die Energieeffizienz, Farbwiedergabe und (Farbpunkt)Stabilität weiter zu erhöhen.

Um durch eine additive Farbmischung weiß emittierende anorganische LEDs (light emitting diodes) zu erhalten, gibt es prinzipiell drei verschiedene Ansätze:

(1) Die RGB LEDs (rot + grün + blau LEDs), bei denen weißes Licht durch Mischung des Lichtes dreier verschiedener im roten, grünen und blauen Spektralbereich emittierender Leuchtdioden erzeugt wird.

(2) Die Systeme UV LED + RGB Leuchtstoff, bei denen ein im UV-Bereich emittierender Halbleiter (Primärlichtquelle) das Licht an die Umgebung abgibt, in der drei verschiedene Leuchtstoffe (Konversionsleuchtstoffe) angeregt werden, im roten, grünen und blauen Spektralbereich zu emittieren. Alternativ können zwei verschiedene Leuchtstoffe verwendet werden, die gelb oder orange und blau emittieren.

(3) Komplementäre Systeme, bei denen ein emittierender Halbleiter (Primärlichtquelle) beispielsweise blaues Licht abgibt, das einen oder mehrere Leuchtstoffe (Konversionsleuchtstoffe) anregt, im beispielsweise gelben Bereich Licht zu emittieren. Durch Mischung des blauen und des gelben Lichts entsteht dann weißes Licht. Alternativ können zwei oder mehrere Leuchtstoffe verwendet werden, die beispielsweise grünes oder gelbes und oranges oder rotes Licht emittieren.

Binär-komplementäre Systeme benötigen bei Verwendung eines blau emittierenden Halbleiters als Primärlichtquelle einen gelben Konversionsleuchtstoff, um weißes Licht wiederzugeben. Alternativ können grün und rot emittierende Konversionsleuchtstoffe verwendet werden. Verwendet man alternativ dazu als Primärlichtquelle einen im violetten Spektralbereich oder im nahen UV-Spektrum emittierenden Halbleiter, so muss entweder eine RGB-Leuchtstoffmischung oder eine dichromatische Mischung aus zwei Konversionsleuchtstoffen, die komplementäres Licht emittieren, verwendet werden, um weißes Licht zu erhalten. Bei der Verwendung eines Systems mit einer Primärlichtquelle im violetten oder UV-Bereich und zwei komplementären Konversionsleuchtstoffen können Leuchtdioden mit einem besonders hohen Lumenäquivalent bereitgestellt werden. Ein weiterer Vorteil einer dichromatischen Leuchtstoffmischung ist die geringere spektrale Wechselwirkung und der damit verbundene höhere "Package Gain" ("Packungsdichte").

Deshalb gewinnen heute insbesondere anorganische Lumineszenzmaterialien, die im ultravioletten und/oder blauen Spektralbereich angeregt werden können, eine immer stärkere Bedeutung als Konversionsleuchtstoffe für Lichtquellen, insbesondere für pc-LEDs zur Erzeugung warm-weißen Lichts.

Es besteht daher ein ständiger Bedarf an neuen Lumineszenzmaterialien, die als Konversionsleuchtstoffe im ultravioletten oder blauen Spektralbereich angeregt werden können und Licht im sichtbaren Bereich, insbesondere im roten Spektralbereich abgeben. Vorrangige Ziele sind daher die Erweiterung des Produktspektrums, die Verbesserung der Farbwiedergabe weißer LEDs und die Realisierung trichromatischer LEDs. Dazu müssen grün-, gelb- und rot-emittierende Leuchtstoffe mit hoher Absorption im blauen, violetten oder UV-Spektralbereich mit einer hohen Quantenausbeute und einem hohen Lumenäquivalent bereitgestellt werden.

Mn(IV)-aktivierte lumineszierende Materialien werden in Fluoreszenzlichtquellen (CFL, TL, LED) und in emittierenden Bildschirmen (Kathodenstrahlröhren) für die Konversion von nicht sichtbarer Strahlung oder Hochenergiepartikeln in sichtbares Licht verwendet. Ein Material, das recht weite Verbreitung für diesen Zweck gefunden hat, ist $Mg_8Ge_2O_{11}F_2$:Mn, dessen Emissionsmaximum bei etwa 660 nm liegt und das sich gut bei 160 nm oder 254 nm aber auch im tiefblauen Spektralbereich anregen lässt. Es ist daher auch bedingt für die Anwendung in leuchtstoffkonvertierten LEDs geeignet, zumal Mn(IV)-dotierte Leuchtstoffe auch bei hohen Temperaturen (100 - 200 °C) effiziente Photolumineszenz zeigen können.

Ein wesentlicher Nachteil der Anwendung von Mn(IV)-aktivierten Leuchtstoffen in Hochleistungs-LED-Festkörperlichtquellen ist der meist relativ geringe Absorptionsquerschnitt im nahen UV-oder im blauen Spektralbereich. Dieser Befund schränkt die ergonomische Anwendung von Mn(IV)-aktivierten Leuchtstoffen als Strahlungskonverter in nah-UV oder blauen LEDs stark ein.

Zudem benötigt man für LEDs mit hoher Farbwiedergabe bei gleichzeitig hoher Lumenausbeute einen roten Leuchtstoff mit einem Emissionsmaximum im roten Spektralbereich von 610 und 640 nm, was in oxidischen Wirtsmaterialien nur bedingt möglich ist.

Darum wird die Suche nach neuen Mn(IV)-aktivierten Leuchtstoffen für LEDs in vielen akademischen und industriellen Forschungslaboratorien, z.B. bei General Electric, weiterhin stark vorangetrieben.

So offenbart beispielsweise die WO 2014/152787 A1 ein Verfahren zur Synthese von farbstabilen Mn(IV)-dotierten Leuchtstoffen, worin beispielsweise $K_2[SiF_6]:Mn^{4+}$, $K_2[TiF_6]:Mn^{4+}$ oder $K_2[SnF_6]:Mn^{4+}$ als Vorstufen in Gasform bei erhöhter Temperatur mit einem fluorhaltigen Oxidationsmittel umgesetzt werden.

Aus der WO 2008/100517 A1 sind lichtemittierende Vorrichtungen mit einer Lichtquelle und einem Leuchtstoffmaterial bekannt, wobei das Leuchtstoffmaterial einen ternären Mn(IV)-aktivierten Fluorid-Phosphor enthält, der mindestens eine der folgenden Verbindungen einschließt: (A) $A_2[MF_5]:Mn_{4+}$, (B) $A_3[MF_6]:Mn^{4+}$, (C) $Zn_2[MF_7]:Mn^{4+}$ oder (D) $A[In_2F_7]:Mn^{4+}$ mit A = Li, Na, K, Rb, Cs und/oder $NH_4$ und M = Al, Ga und/oder In.

Oxidische Fluoridverbindungen mit Mn(IV)-Aktivierung sind aus der CN 106800930 A bekannt. Die roten Leuchtstoffe bestehen aus einem Material mit der allgemeinen Formel $A_{2-x}B_x(MoO_2F_4)H_2O:Mn^{4+}_y$, wobei A und B verschieden sind und unabhängig Na, K, Cs oder Rb darstellen; x ein Wert von 0 bis 1 ist; und y ein Wert von 0,03 bis 0,16 ist. Die in der Verbindung vorhandenen Kristallwasser-Einheiten bewirken durch ihre OH-Schwingung eine Multiphononenrelaxation, wodurch der Leuchtstoff gequencht wird. Der in der CN 106800930 A beschriebene Leuchtstoff zeichnet sich somit durch eine geringe Quantenausbeute aus.

Rote Leuchtstoffverbindungen der allgemeinen Formel $A_2[MO_2F_4]:Mn^{4+}$ sind aus der CN 107043624 A bekannt, wobei A Na, K, Rb oder Cs sein kann; und M Mo oder W ist. Diese Verbindungen sind allerdings stark hygroskopisch und zersetzen sich nach einiger Zeit an Luft. Sie weisen zudem eine niedrige Quantenausbeute auf.

Die aus dem Stand der Technik bekannten Lumineszenzmaterialien werden üblicherweise durch Umsetzen einer Vorläuferverbindung mit einem fluorhaltigen Oxidationsmittel in der Gasphase bei erhöhter Temperatur oder in wässriger Phase erhalten. Die Verwendung solcher hoch-korrosiven fluorhaltigen Oxidationsmittel stellt hohe apparative Anforderungen an das Reaktionsgefäß sowie dessen Material. Hierdurch wird die Synthese aufwändig und teuer.

Ein weiterer Nachteil der bisher bekannten Mn(IV)-dotierten Fluoride ist deren geringe Stabilität, insbesondere in Gegenwart von Luft und/oder Feuchtigkeit oder unter Bestrahlung mit blauem Licht oder UV-Strahlung. Bei letzterer setzen die Fluoride partiell Fluor frei, wodurch im Material selbst Fehlstellen zurückbleiben und Mn(IV) reduziert wird. Hierdurch wird die Lebensdauer und Stabilität der Leuchtstoffe und damit in Folge die Farbtemperatur der LED beeinträchtigt.

## Aufgabe der Erfindung

Aufgabe der vorliegenden Erfindung ist es, eine Lichtquelle bereitzustellen, die sich insbesondere zur Erzeugung von warm-weißem Licht eignet und ein Lumineszenzmaterial umfasst, welches sich durch einen breiten Absorptionsquerschnitt im nahen UV- bis blauen Spektralbereich auszeichnet, ein Emissionsmaximum im roten Spektralbereich zwischen 610 und 640 nm aufweist und somit eine hohe Farbwiedergabe ermöglicht. Hierdurch sollen warm-weiße pc-LEDs mit hohen Farbwiedergabewerten bei niedrigen Farbtemperaturen (CCT < 4000 K) bei gleichzeitiger hoher Lichtausbeute realisiert werden können.

## Beschreibung der Erfindung

Die genannte Aufgabe wird gelöst durch eine Lichtquelle gemäß dem beigefügten Anspruch 1.

Die Lichtquelle enthält mindestens eine Primärlichtquelle und mindestens eine Verbindung in Form eines Lumineszenzmaterials oder eine strahlungskonvertierende Mischung umfassend das Lumineszenzmaterial. Dabei liegt das Emissionsmaximum der Primärlichtquelle üblicherweise im Bereich von etwa 250 bis etwa 550 nm, vorzugsweise im Bereich von etwa 325 bis etwa 525 nm, wobei die primäre Strahlung teilweise oder vollständig durch die strahlungskonvertierende Mischung in längerwellige Strahlung konvertiert wird.

Die strahlungskonvertierende Mischung kann aus einer oder mehreren Verbindungen bestehen und wäre somit mit dem unten definierten Begriff "Leuchtstoff" oder "Konversionsleuchtstoff" gleichzusetzen.

Im Rahmen der vorliegenden Erfindung werden Mn(IV)-aktivierte Lumineszenzmaterialien offenbart, die auf einem Oxidohalogenid-Wirtsgitter der allgemeinen Form:

$(A_{4-a}B_a)_{m/2+n/2}X_{2m}[MX_4O_2]_n$ (mit A = H und/oder D, wobei D Deuterium ist; B = Li, Na, K, Rb, Cs, $NH_4$, $ND_4$ und/oder $NR_4$, wobei R ein Alkyl- oder Arylrest ist; X = F und/oder Cl; M = Cr, Mo, W und/oder Re; $0 \leq a \leq 4$; $0 < m \leq 10$; und $1 \leq n \leq 10$) basieren.

Die Erfinder haben überraschenderweise gefunden, dass rot emittierende Lumineszenzmaterialien mit Emissionsmaxima im Bereich zwischen 610 und 640 nm, hoher Quantenausbeute, hoher Farbwiedergabe, hoher Lebensdauer und hoher Stabilität der Farbtemperatur dadurch realisiert werden können, indem Mn(IV)-Ionen in das Oxidohalogenid-Wirtsgitter der allgemeinen Form: $(A_{4-a}B_a)_{m/2+n/2}X_{2m}[MX_4O_2]_n$ (mit A = H und/oder D, wobei D Deuterium ist; B = Li, Na, K, Rb, Cs, $NH_4$, $ND_4$ und/oder $NR_4$, wobei R ein Alkyl- oder Arylrest ist; X = F und/oder Cl; M = Cr, Mo, W und/oder Re; $0 \leq a \leq 4$; $0 < m \leq 10$; und $1 \leq n \leq 10$) eingebaut werden, so dass Verbindungen der allgemeinen Zusammensetzung: $(A_{4-a}B_a)_{m/2+n/2}X_{2m}[MX_4O_2]_n$:Mn(IV) erhalten werden.

Darüber hinaus sind die Lumineszenzmaterialien durch eine einfache Synthese effizient und kostengünstig zugänglich, wobei sich insbesondere Cr(VI), Mo(VI), W(VI) und Re(VI) anbieten, um langzeitstabile Fluorid-Verbindungen zu realisieren, denn die zugehörigen oktaedrischen Oxidohalogenid-Komplexanionen der allgemeinen Form $[MX_4O_2]^{2-}$ verfügen über eine außerordentlich hohe Stabilität. Bei mikroskaligen Pulvern der offenbarten Lumineszenzmaterialien tritt somit keine Grauverfärbung auf, da eine Bildung von $MnO_2$ ausbleibt. Zudem zeigen die offenbarten Oxidohalogenide aufgrund ihrer höheren Gitterenergie im Vergleich zu Fluoriden eine größere Stabilität. Insbesondere bei Wolframaten ist zu beobachten, dass durch eine starke π-Rückbindung, die effektive Ionenladungsdichte an den Halogenid- und W(VI)-Ionen reduziert wird.

Der Einbau der vierwertigen Mn(IV)-Ionen erfolgt auf den kristallographischen Lagen der sechswertigen M-Ionen (M = Cr(VI), Mo(VI), W(VI) und/oder Re(VI)). Die Dotierung mit Mn(IV) gestattet eine einfache und effiziente Synthese, da sich die Mn(IV)-Ionen gut in die Kristallstruktur des Wirtsgitters einfügen. Der Ladungsausgleich erfolgt durch zusätzlichen Einbau von Halogenid sowie Sauerstofffehlstellen im Wirtsgitter.

Bei Verbindungen dieser allgemeinen Zusammensetzung handelt es sich um rot-emittierende Mn(IV)-Lumineszenzmaterialien, deren Emissionslinienmultiplett im roten Spektralbereich ein Maximum zwischen 610 und 640 nm, insbesondere im Bereich zwischen 620 und 635 nm, aufweist.

Ferner eignen sich die offenbarten Verbindungen für die Verwendung als Konversionsleuchtstoffe in Festkörperstrahlungsquellen jeglicher Art, wie beispielsweise LED-Festkörperlichtquellen oder Hochleistungs-LED-Festkörperlichtquellen. Die CIE1931 Farbkoordinaten aller hier offenbarten Materialien liegen bei x > 0,66 und y < 0,33 und das Lumenäquivalent ist höher als 200 lm/W, vorzugsweise höher als 220 lm/W.

Es handelt sich somit um Verbindungen der folgenden allgemeinen Formel (I):

$$(A_{4-a}B_a)_{m/2+n/2}X_{2m}[MX_4O_2]_n \qquad (I),$$

die mit Mn(IV) dotiert sind, wobei für die verwendeten Symbole und Indizes gilt:

A    ist ausgewählt aus der Gruppe bestehend aus H und D und Mischungen davon, wobei D Deuterium ist;

B    ist ausgewählt aus der Gruppe bestehend aus Li, Na, K, Rb, Cs, $NH_4$, $ND_4$, $NR_4$ und Mischungen aus zwei oder mehreren davon, wobei R ein Alkyl- oder Arylrest ist;

X    ist ausgewählt aus der Gruppe bestehend aus F und Cl und Mischungen davon;

M    ist ausgewählt aus der Gruppe bestehend aus Cr, Mo, W, Re und Mischungen aus zwei oder mehreren davon;

$0 \leq a \leq 4$; $0 < m \leq 10$; und $1 \leq n \leq 10$.

Bevorzugte Alkylreste sind lineare C1-C5-Alkylreste oder verzweigte C3-C5-Alkylreste. Besonders bevorzugt Alkylreste sind Methyl, Ethyl, Propyl, Butyl und Pentyl.

Bevorzugte Arylreste sind Phenyl, Naphthyl, Anthryl und Phenanthryl, die wahlweise mit einem oder mehreren Resten, ausgewählt aus Methyl, Ethyl, Propyl, Butyl, Methoxy, Ethoxy, Hydroxyl, Fluorid, Chlorid und Trifluormethyl substituiert sein können.

In der obigen allgemeinen Formel (I) ist A ein einfach geladenes Wasserstoff- und/oder Deuteriumkation $A^+$ und B ein einfach geladenes Metall- und/oder Ammoniumkation $B^+$. M ist ein sechsfach geladenes Metallatom $M^{6+}$. Mn(IV) liegt als vierfach geladenes Metallatom $Mn^{4+}$ vor, während das Halogen X als Halogenid ($X^-$) und Sauerstoff O als Oxid ($O^{2-}$) vorliegen. Die offenbarten Mn(IV)-aktivierten Lumineszenzmaterialien sind Konversionsmaterialien, die mit $Mn^{4+}$ dotiert sind, wobei ein $Mn^{4+}$-Ion und zwei $X^-$-Ionen ein $M^{6+}$-Ion und zwei $O^{2-}$-Ionen ersetzen. Der Ladungsausgleich erfolgt somit durch den zusätzlichen Einbau von zwei $X^-$-Ionen und den Wegfall von zwei $O^{2-}$-Ionen.

Die offenbarten Verbindungen sind üblicherweise im Spektralbereich von etwa 250 bis etwa 550 nm, vorzugsweise von etwa 325 bis etwa 525 nm, anregbar, wobei das Absorptionsmaximum zwischen 425 und 500 nm liegt, und emittieren üblicherweise im roten Spektralbereich von etwa 600 bis etwa 650 nm, wobei das Emissionsmaximum im Bereich zwischen 610 und 640 nm, vorzugsweise zwischen 620 und 635 nm, liegt. Die offenbarten Verbindungen zeigen zudem eine hohe Photolumineszenz-Quantenausbeute und weisen eine hohe spektrale Reinheit sowie eine hohe Stabilität der Farbtemperatur bei Verwendung in einer LED auf.

Im Kontext dieser Anmeldung wird als ultraviolettes Licht solches Licht bezeichnet, dessen Emissionsmaximum zwischen 100 und 399 nm liegt, als violettes Licht solches Licht bezeichnet, dessen Emissionsmaximum zwischen 400 und 430 nm liegt, als blaues Licht solches Licht bezeichnet, dessen Emissionsmaximum zwischen 431 und 480 nm liegt, als cyanfarbiges Licht solches, dessen Emissionsmaximum zwischen 481 und 510 nm liegt, als grünes Licht solches, dessen Emissionsmaximum zwischen 511 und 565 nm liegt, als gelbes Licht solches, dessen Emissionsmaximum zwischen 566 und 575 nm liegt, als oranges Licht solches, dessen Emissionsmaximum zwischen 576 und 600 nm liegt und als rotes Licht solches, dessen Emissionsmaximum zwischen 601 und 750 nm liegt.

In einer bevorzugten Ausführungsform sind die mit Mn(IV) dotierten Verbindungen der allgemeinen Formel (I) durch die folgende allgemeine Formel (II) dargestellt:

$$(A_{4-a}B_a)_{m/2+n/2}X_{2m}[M_{1-x}X_{4+2x}O_{2-2x}]_n:[Mn(IV)_x]_n \qquad (II),$$

wobei für die verwendeten Symbole und Indizes gilt:

A     ist ausgewählt aus der Gruppe bestehend aus H und D und Mischungen davon, wobei D Deuterium ist;

B     ist ausgewählt aus der Gruppe bestehend aus Li, Na, K, Rb, Cs, $NH_4$, $ND_4$, $NR_4$ und Mischungen aus zwei oder mehreren davon, wobei R ein Alkyl- oder Arylrest ist;

X     ist ausgewählt aus der Gruppe bestehend aus F und Cl und Mischungen davon;

M     ist ausgewählt aus der Gruppe bestehend aus Cr, Mo, W, Re und Mischungen aus zwei oder mehreren davon; und

$0 \leq a \leq 4$; $0 < m \leq 10$; $1 \leq n \leq 10$; und $0 < x < 1,0$.

Es ist bevorzugt, dass für den Index a in den allgemeinen Formeln (I) und (II) gilt: $1 \leq a \leq 4$ und stärker bevorzugt $2,0 \leq a \leq 4,0$. In einer bevorzugten Ausführungsform ist a in den allgemeinen Formeln (I) und (II) eine ganze Zahl von 1 bis 4 und stärker bevorzugt eine ganze Zahl, ausgewählt aus 2, 3 und 4. Am stärksten bevorzugt gilt in den allgmeinen Formeln (I) und (II): a = 3,0.

Es ist bevorzugt, dass für den Index m in den allgemeinen Formeln (I) und (II) gilt: $0,1 \leq m \leq 5$, stärker bevorzugt $0,5 \leq m \leq 3,0$ und am stärksten bevorzugt $0,75 \leq m \leq 1,50$. In einer bevorzugten Ausführungsform ist m in den allgemeinen Formeln (I) und (II) eine ganze Zahl, ausgewählt aus 1, 2 und 3. Am stärksten bevorzugt gilt in den allgemeinen Formeln (I) und (II): m = 1,0.

Es ist bevorzugt, dass für den Index n in den allgemeinen Formeln (I) und (II) gilt: $1 \leq n \leq 5$ und stärker bevorzugt $1,0 \leq n \leq 3,0$. In einer bevorzugten Ausführungsform ist n in den allgemeinen Formeln (I) und (II) eine ganze Zahl von 1 bis 5 und stärker bevorzugt eine ganze Zahl, ausgewählt aus 1, 2 und 3. Am stärksten bevorzugt gilt in den allgmeinen Formeln (I) und (II): n = 1,0.

In einer besonders bevorzugten Ausführungsform sind die mit Mn(IV) dotierten Verbindungen der allgemeinen Formel (I) bzw. die Verbindungen der allgemeinen Formel (II) durch die folgende allgemeine Formel (III) dargestellt:

$$AB_3M_{1-x}X_{6+2x}O_{2-2x}:Mn(IV)_x \qquad (III),$$

wobei A, B, X und M eine der oben für die allgemeine Formel (I) und/oder allgemeine Formel (II) beschriebenen Definitionen aufweisen und für x gilt:

$$0 < x < 1,0.$$

Vorzugsweise ist A in den allgemeinen Formeln (I), (II) und/oder (III) H oder D, wobei D Deuterium ist, stärker bevorzugt ist A H.

Vorzugsweise ist B in den allgemeinen Formeln (I), (II) und/oder (III) ausgewählt aus der Gruppe bestehend aus Na, K, Cs und Mischungen aus zwei oder drei davon; stärker bevorzugt ist A ausgewählt aus der Gruppe bestehend aus Na und K.

Vorzugsweise ist X in den allgemeinen Formeln (I), (II) und/oder (III) F, wobei wahlweise bis zu 10 Atom-%, stärker bevorzugt bis zu 5 Atom-%, von X Cl ist. Besonders bevorzugt ist X in den allgemeinen Formeln (I), (II) und/oder (III) F.

Vorzugsweise ist M in den allgemeinen Formeln (I), (II) und/oder (III) ausgewählt aus der Gruppe bestehend aus Mo, W und Mischungen aus Mo und W, wobei optional Cr und/oder Re enthalten sein kann. Stärker bevorzugt ist M in den allgemeinen Formeln (I), (II) und/oder (III) ausgewählt aus Mischungen bestehend aus Cr und Mo; Mo und W; Cr und W; Cr und Re; Mo und Re; W und Re; Cr, Mo und W; Cr, Mo und Re; Cr, W und Re; Mo, W und Re; sowie Cr, Mo, W und Re.

In einer bevorzugten Ausführungsform der Erfindung gilt für den Index x in den allgemeinen Formeln (II) und (III): $0 < x \leq 0,80$, stärker bevorzugt $0 < x \leq 0,60$, weiterhin stärker bevorzugt $0,0001 < x \leq 0,40$, besonders bevorzugt $0,001 \leq x \leq 0,20$, weiterhin besonders bevorzugt $0,001 \leq x \leq 0,10$ und am stärksten bevorzugt $0,002 \leq x \leq 0,05$.

In einer besonders bevorzugten Ausführungsform gelten mehrere der oben genannten bevorzugten Merkmale gleichzeitig, unabhängig davon, ob es sich um bevorzugte, stärker bevorzugte, besonders bevorzugte und/oder am stärksten bevorzugte Merkmale handelt.

Besonders bevorzugt sind daher Verbindungen der allgemeinen Formeln (II) oder (III), für die folgendes gilt:

A    ist ausgewählt aus der Gruppe bestehend aus H und D und Mischungen davon, wobei D Deuterium ist;

B    ist ausgewählt aus der Gruppe bestehend aus Na, K, Rb und Mischungen aus zwei oder drei davon;

X    ist F;

M    ist ausgewählt aus der Gruppe bestehend aus Mo, W und Mischungen aus Mo und W, wobei optional Cr und/oder Re enthalten sein kann; und

$0,0001 < x \leq 0,40$, stärker bevorzugt $0,001 \leq x \leq 0,20$, besonders bevorzugt $0,001 \leq x \leq 0,10$ und am stärksten bevorzugt $0,002 \leq x \leq 0,05$.

Bei den besonders bevorzugten Verbindungen der allgemeinen Formel (II) gilt zudem:

$1 \leq a \leq 4$, stärker bevorzugt $2,0 \leq a \leq 4,0$ und am stärksten bevorzugt $a = 3,0$;

$0,5 \leq m \leq 3,0$, stärker bevorzugt $0,75 \leq m \leq 1,50$ und am stärksten bevorzugt $m = 1,0$; und

$1 \leq n \leq 5$, stärker bevorzugt $1,0 \leq n \leq 3,0$ und am stärksten bevorzugt $n = 1,0$.

Die offenbarte Verbindung kann vorzugsweise auf ihrer Oberfläche mit einer anderen Verbindung beschichtet sein, wie weiter unten beschrieben wird.

Ein Verfahren zur Herstellung einer Verbindung gemäß der allgemeinen Formel (I), (II) und/oder (III) umfasst die folgenden Schritte:

a) Herstellung einer Suspension/Lösung enthaltend A, B, M und Mn in einer AX-haltigen Lösung;
b) Rühren der Suspension/Lösung; und
c) Abtrennung des erhaltenen Feststoffes.

Die Herstellung der Suspension/Lösung in Schritt a) erfolgt durch Suspendieren/Auflösen von Salzen, die B, M, und Mn enthalten, in einer AX-haltigen Lösung. Dabei können die Salze in Schritt a) entweder nacheinander in beliebiger Reihenfolge oder gleichzeitig zugegeben werden. Die Salze können entweder als Feststoffe oder als Suspensionen/ Lösungen zugegeben werden. Als AX-haltige Lösung wird eine HX-haltige Lösung und/oder eine DX-haltige Lösung verwendet. Bevorzugte HX-haltige Lösungen sind eine HF-Lösung und eine HCl-Lösung. Bevorzugte DX-haltige Lösungen sind eine DF-Lösung und eine DCl-Lösung.

Als HF-Lösung wird vorzugsweise eine konzentrierte HF-Lösung verwendet. Vorzugsweise wird konzentrierte wässrige HF-Lösung (Flusssäure) mit 10 - 60 Gew.-% HF, stärker bevorzugt 20 - 50 Gew.-% HF und am stärksten bevorzugt 30 - 40 Gew.-% HF, in dem offenbarten Herstellungsverfahren verwendet. Als HCl-Lösung wird vorzugsweise eine konzentrierte HCl-Lösung verwendet. Vorzugsweise wird konzentrierte wässrige HCl-Lösung (Salzsäure) mit 35 - 37 Gew.-% HCl in dem offenbarten Herstellungsverfahren verwendet. Die Herstellung einer DF-Lösung erfolgt vorzugsweise aus $D_2SO_4$ und $CaF_2$. Das erhaltene DF-Gas wird anschließend in $D_2O$ eingeleitet, so dass eine DF-Lösung erhalten wird. Als DCl-Lösung wird vorzugsweise eine konzentrierte Lösung von 35 - 37 Gew.-% DCl in $D_2O$ verwendet.

Bei dem Verfahren zur Herstellung einer Verbindung gemäß der allgemeinen Formel (I), (II) und/oder (III) werden in Schritt a) als Salz für die Ionen $B^+$ und $M^{6+}$ vorzugsweise Halogenid- bzw. Oxidverbindungen als Ausgangsverbindungen eingesetzt, wie beispielsweise $B_2MO_4$, BX und $BHX_2$. Bevorzugte Verbindungen $B_2MO_4$ sind: $Li_2CrO_4$,

$Na_2CrO_4$, $K_2CrO_4$, $Rb_2CrO_4$, $Cs_2CrO_4$, $Li_2MoO_4$, $Na_2MoO_4$, $K_2MoO_4$, $Rb_2MoO_4$, $Cs_2MoO_4$, $Li_2WO_4$, $Na_2WO_4$, $K_2WO_4$, $Rb_2WO_4$, $Cs_2WO_4$, $Li_2ReO_4$, $Na_2ReO_4$, $K_2ReO_4$, $Rb_2ReO_4$ und $Cs_2ReO_4$. Bevorzugte Halogenid-Verbindungen BX sind: LiF, LiCl, NaF, NaCl, KF, KCl, RbF, RbCl, $NH_4F$, $NH_4Cl$, $ND_4F$, $ND_4Cl$, CsF und CsCl. Bevorzugte Halogenid-Verbindungen $BHX_2$ sind: $NaHF_2$, $KHF_2$, $RbHF_2$, $[NH_4]HF_2$, $[ND_4]DF_2$ und $CsHF_2$.

Mn wird in Schritt a) bevorzugt in Form von vierwertigen Mangansalzen als Ausgangsverbindungen, wie beispielsweise $B_2MnX_6$, eingesetzt. Bevorzugte vierwertige Mangansalze $BMnX_6$ sind $Li_2MnF_6$, $Li_2MnCl_6$, $Na_2MnF_6$, $Na_2MnCl_6$, $K_2MnF_6$, $K_2MnCl_6$, $Rb_2MnF_6$, $Rb_2MnCl_6$, $Cs_2MnF_6$ und $Cs_2MnCl_6$.

Das Suspendieren/Lösen der Ausgangsverbindungen kann bei Temperaturen zwischen -10 und 100 °C, vorzugsweise zwischen 0 und 50 °C, stärker bevorzugt zwischen 10 und 40 °C und am stärksten bevorzugt zwischen 15 und 30 °C, erfolgen.

Das Rühren der Suspension/Lösung in Schritt b) erfolgt bevorzugt bei Temperaturen zwischen -10 und 100 °C, vorzugsweise zwischen 0 und 50 °C, stärker bevorzugt zwischen 10 und 40 °C und am stärksten bevorzugt zwischen 15 und 30 °C für einen Zeitraum bis zu 10 h, vorzugsweise bis zu 6 h, stärker bevorzugt bis zu 4 h und am stärksten bevorzugt bis zu 3 h. Bevorzugte Zeiträume für das Rühren der Suspension/Lösung in Schritt b) sind 0,1 bis 10 h, 0,5 bis 6 h, 1 bis 4 h und 2 bis 3 h. In einer bevorzugten Ausführungsform erfolgt das Rühren der Suspension/Lösung in Schritt b) bei einer Temperatur zwischen 15 und 30 °C für 2 bis 3 h.

Die Abtrennung des erhaltenen Feststoffes in Schritt c) erfolgt vorzugsweise durch Filtrieren, Zentrifugieren oder Dekantieren, stärker bevorzugt durch Filtrieren über eine Nutsche.

In einer bevorzugten Ausführungsform schließt sich an Schritt c) ein weiterer Schritt d) an, in dem der in Schritt c) erhaltene Feststoff gewaschen und getrocknet wird. Das Waschen des Feststoffs erfolgt vorzugsweise mit einem organischen Lösungsmittel bis der Feststoff säurefrei ist. Bevorzugt sind organische aprotische Lösungsmittel wie beispielsweise Aceton, Hexan, Heptan, Oktan, Dimethylformamid (DMF) und Dimethylsulfoxid (DMSO). Das zum Waschen verwendete Lösungsmittel hat vorzugsweise eine Temperatur von -10 bis 20 °C.

Das Trocknen des Feststoffs in Schritt d) erfolgt bevorzugt unter vermindertem Druck. Das Trocknen kann bei Raumtemperatur (20 bis 25 °C) oder bei einer erhöhten Temperatur, wie beispielsweise 25 bis 150 °C, erfolgen. Nach dem Trocknen in Schritt d) wird das gewünschte Lumineszenzmaterial erhalten.

In einer weiteren Ausführungsform können die offenbarten Lumineszenzmaterialien beschichtet werden. Hierfür eignen sich alle Beschichtungsverfahren, wie sie aus dem Stand der Technik dem Fachmann bekannt sind und sie für Leuchtstoffe angewandt werden. Geeignete Materialien für die Beschichtung sind insbesondere amorpher Kohlenstoff (diamantähnlicher Kohlenstoff, DLC (engl.: diamond like carbon)), Metalloxide, Metallfluoride und Metallnitride, insbesondere Erdmetalloxide, wie $Al_2O_3$, Erdmetallfluoride wie $CaF_2$ und Erdmetallnitride, wie AlN, sowie $SiO_2$. Dabei kann die Beschichtung beispielsweise durch Wirbelschichtverfahren oder nasschemisch durchgeführt werden. Geeignete Beschichtungsverfahren sind beispielsweise bekannt aus JP 04-304290, WO 91/10715, WO 99/27033, US 2007/0298250, WO 2009/065480 und WO 2010/075908, welche hiermit durch Bezugnahme eingeschlossen sind. Das Ziel der Beschichtung kann einerseits eine höhere Stabilität der Lumineszenzmaterialien, beispielsweise gegen Luft oder Feuchtigkeit, sein. Ziel kann aber auch eine verbesserte Ein-und Auskopplung von Licht durch geeignete Wahl der Oberfläche der Beschichtung sowie der Brechungsindizes des Beschichtungsmaterials sein.

Es wird die Verwendung der offenbarten Lumineszenzmaterialien als Leuchtstoff oder Konversionsleuchtstoff gezeigt, insbesondere zur teilweisen oder vollständigen Konversion von UV-Licht, violettem Licht und/oder blauem Licht in energieärmeres Licht, d.h. in Licht mit größerer Wellenlänge.

Die offenbarten Verbindungen werden daher auch als Leuchtstoffe bezeichnet.

Bevorzugt ist, dass die strahlungskonvertierende Mischung neben der einen offenbarten Verbindung ein oder mehrere weitere Lumineszenzmaterialien umfasst. Bevorzugte Lumineszenzmaterialien sind Konversionsleuchtstoffe, die von den offenbarten Verbindungen verschieden sind, oder Halbleiter-Nanopartikel (Quantenmaterialien).

In einer besonders bevorzugten Ausführungsform umfasst die strahlungskonvertierende Mischung eine offenbarte Verbindung und einen weiteren Konversionsleuchtstoff. Ganz besonders bevorzugt ist es, dass die offenbarte Verbindung und der weitere Konversionsleuchtstoff jeweils Licht mit zueinander komplementären Wellenlängen emittieren.

In einer alternativen besonders bevorzugten Ausführungsform umfasst die strahlungskonvertierende Mischung eine offenbarte Verbindung und ein Quantenmaterial. Ganz besonders bevorzugt ist es, dass die offenbarte Verbindung und das Quantenmaterial jeweils Licht mit zueinander komplementären Wellenlängen emittieren.

In einer weiteren alternativen besonders bevorzugten Ausführungsform umfasst die strahlungskonvertierende Mischung eine offenbarte Verbindung, ein Konversionsleuchtstoff und ein Quantenmaterial.

Werden die offenbarten Verbindungen in geringen Mengen eingesetzt, so ergeben sie bereits gute LED-Qualitäten. Die LED-Qualität wird dabei mit üblichen Parametern, wie beispielsweise den Color Rendering Index (CRI), die Correlated Color Temperature (CCT), Lumenäquivalente oder absolute Lumen bzw. den Farbpunkt in CIE x und y Koordinaten, beschrieben.

Der Color Rendering Index (CRI) ist eine dem Fachmann geläufige, einheitslose lichttechnische Größe, welche die Farbwiedergabetreue einer künstlichen Lichtquelle mit derjenigen des Sonnenlichtes bzw. und Filamentlichtquellen vergleicht (die beiden zuletzt genannten besitzen einen CRI von 100).

Die Correlated Color Temperature (CCT) ist eine dem Fachmann geläufige, lichttechnische Größe mit der Einheit Kelvin. Je höher der Zahlenwert, desto höher ist der Blauanteil des Lichts und desto kälter erscheint dem Betrachter das Weißlicht einer künstlichen Strahlungsquelle. Die CCT folgt dem Konzept des Schwarzlichtstrahlers, dessen Farbtemperatur die sogenannte Planck'sche Kurve im CIE Diagramm beschreibt.

Das Lumenäquivalent ist eine dem Fachmann geläufige lichttechnische Größe mit der Einheit lm/W, die beschreibt, wie groß der photometrische Lichtstrom in Lumen einer Lichtquelle bei einer bestimmten radiometrischen Strahlungsleistung mit der Einheit Watt, ist. Je höher das Lumenäquivalent ist, desto effizienter ist eine Lichtquelle.

Der Lichtstrom mit der Einheit Lumen ist eine dem Fachmann geläufige, photometrische lichttechnische Größe, welche den Lichtstrom einer Lichtquelle, der ein Maß für die gesamte von einer Strahlungsquelle ausgesandte sichtbare Strahlung ist, beschreibt. Je größer der Lichtstrom, desto heller erscheint die Lichtquelle dem Beobachter.

CIE x und CIE y stehen für die Koordinaten im dem Fachmann geläufigen CIE Normfarbdiagramm (hier Normalbeobachter 1931), mit denen die Farbe einer Lichtquelle beschrieben wird.

Alle oben aufgeführten Größen können mit dem Fachmann bekannten Methoden aus den Emissionsspektren der Lichtquelle berechnet werden.

Die Anregbarkeit der offenbarten Leuchtstoffe erstreckt sich über einen weiten Bereich, der von etwa 250 bis etwa 550 nm, vorzugsweise von etwa 325 bis etwa 525 nm, reicht.

In einer bevorzugten Ausführungsform der erfindungsgemäßen Lichtquelle umfasst die Primärlichtquelle ein lumineszentes Indium-Aluminium-Gallium-Nitrid, insbesondere der Formel $In_iGa_jAl_kN$, wobei $0 \leq i$, $0 \leq j$, $0 \leq k$, und $i + j + k = 1$ ist. Dem Fachmann sind mögliche Formen von derartigen Lichtquellen bekannt. Es kann sich hierbei um lichtemittierende LED-Chips unterschiedlichen Aufbaus handeln.

In einer weiteren bevorzugten Ausführungsform der erfindungsgemäßen Lichtquelle handelt es sich bei der Primärlichtquelle um eine lumineszente auf ZnO, TCO (transparent conducting oxide), ZnSe oder SiC basierende Anordnung oder auch um eine auf einer organischen lichtemittierenden Schicht basierende Anordnung (OLED).

In einer weiteren bevorzugten Ausführungsform der erfindungsgemäßen Lichtquelle handelt es sich bei der Primärlichtquelle um eine Quelle, die Elektrolumineszenz und/oder Photolumineszenz zeigt. Weiterhin kann es sich bei der Primärlichtquelle auch um eine Plasma- oder Entladungsquelle handeln.

Entsprechende erfindungsgemäße Lichtquellen werden auch als Leuchtdioden oder LEDs bezeichnet.

Die offenbarten Lumineszenzmaterialien können einzeln oder als Mischung mit geeigneten Lumineszenzmaterialien, die dem Fachmann geläufig sind, eingesetzt werden. Entsprechende Lumineszenzmaterialien, die für Mischungen prinzipiell geeignet sind, sind Konversionsleuchtstoffe oder Quantenmaterialien.

Konversionsleuchtstoffe, die zusammen mit dem offenbarten Lumineszenzmaterial eingesetzt werden können und die strahlungskonvertierende Mischung bilden, unterliegen keiner besonderen Einschränkung. Es kann daher generell jeder mögliche Konversionsleuchtstoff verwendet werden. Dabei eignen sich insbesondere: $Ba_2SiO_4:Eu^{2+}$, $Ba_3SiO_5:Eu^{2+}$, $(Ba,Ca)_3SiO_5:Eu^{2+}$, $BaSi_2N_2O_2:Eu$, $BaSi_2O_5:Pb^{2+}$, $Ba_3Si_6O_{12}N_2:Eu$, $Ba_xSr_{1-x}F_2:Eu^{2+}$ (mit $0 \leq x \leq 1$), $BaSrMgSi_2O_7:Eu^{2+}$, $BaTiP_2O_7$, $(Ba,Ti)_2P_2O_7:Ti$, $BaY_2F_8:Er^{3+}$, $Yb^+$, $Be_2SiO_4:Mn^{2+}$, $Bi_4Ge_3O_{12}$, $CaAl_2O_4:Ce^{3+}$, $CaLa_4O_7:Ce^{3+}$, $CaAl_2O_4:Eu^{2+}$, $CaAl_2O_4:Mn^{2+}$, $CaAl_4O-7:Pb^{2+},Mn^{2+}$, $CaAl_2O_4:Tb^{3+}$, $Ca_3Al_2Si_3O_{12}:Ce^{3+}$, $Ca_3Al_2Si_3O_{12}:Ce^{3+}$, $Ca_3Al_2Si_3O_{12}:Eu^{2+}$, $Ca_2B_5O_9Br:Eu^{2+}$, $Ca_2B_5O_9Cl:Eu^{2+}$, $Ca_2B_5O_9Cl:Pb^{2+}$, $CaB_2O_4:Mn^{2+}$, $Ca_2B_2O_5:Mn^{2+}$, $CaB_2O_4:Pb^{2+}$, $CaB_2P_2O_9:Eu^{2+}$, $Ca_5B_2SiO_{10}:Eu^{3+}$, $Ca_{0.5}Ba_{0.5}Al_{12}O_{19}:Ce^{3+},Mn^{2+}$, $Ca_2Ba_3(PO_4)_3Cl:Eu^{2+}$, $CaBr_2:Eu^{2+}$ in $SiO_2$, $CaCl_2:Eu^{2+}$ in $SiO_2$, $CaCl_2:Eu^{2+},Mn^{2+}$ in $SiO_2$, $CaF_2:Ce^{3+}$, $CaF_2:Ce^{3+},Mn^{2+}$, $CaF_2:Ce^{3+},Tb^{3+}$, $CaF_2:Eu^{2+}$, $CaF_2:Mn^{2+}$, $CaGa_2O_4:Mn^{2+}$, $CaGa_4O_7:Mn^{2+}$, $CaGa_2S_4:Ce^{3+}$, $CaGa_2S_4:Eu^{2+}$, $CaGa_2S_4:Mn^{2+}$, $CaGa_2S_4:Pb^{2+}$, $CaGeO_3:Mn^{2+}$, $CaI_2:Eu^{2+}$ in $SiO_2$, $CaI_2:Eu^{2+},Mn^{2+}$ in $SiO_2$, $CaLaBO_4:Eu^{3+}$, $CaLaB_3O_7:Ce^{3+},Mn^{2+}$, $Ca_2La_2BO_{6.5}:Pb^{2+}$, $Ca_2MgSi_2O_7$, $Ca_2MgSi_2O_7:Ce^{3+}$, $CaMgSi_2O_6:Eu^{2+}$, $Ca_3MgSi_2O_8:Eu^{2+}$, $Ca_2MgSi_2O_7:Eu^{2+}$, $CaMgSi_2O_6:Eu^{2+},Mn^{2+}$, $Ca_2Mg_9Si_2O_7:Eu^{2+},Mn^{2+}$, $CaMoO_4$, $CaMoO_4:Eu^{3+}$, $CaO:Bi^{3+}$, $CaO:Cd^{2+}$, $CaO:Cu^+$, $CaO:Eu^{3+}$, $CaO:Eu^{3+}$, $Na^+$, $CaO:Mn^{2+}$, $CaO:Pb^{2+}$, $CaO:Sb^{3+}$, $CaO:Sm^{3+}$, $CaO:Tb^{3+}$, $CaO:Tl$, $CaO:Zn^{2+}$, $Ca_2P_2O_7:Ce^{3+}$, $\alpha\text{-}Ca_3(PO_4)_2:Ce^{3+}$, $\beta\text{-}Ca_3(PO_4)_2:Ce^{3+}$, $Ca_5(PO_4)_3Cl:Eu^{2+}$, $Ca_5(PO_4)_3Cl:Mn^{2+}$, $Ca_5(PO_4)_3Cl:Sb^{3+}$, $Ca_5(PO_4)_3Cl:Sn^{2+}$, $\beta\text{-}Ca_3(PO_4)_2:Eu^{2+},Mn^{2+}$, $Ca_5(PO_4)_3F:Mn^{2+}$, $Ca_5(PO_4)_3F:Sb^{3+}$, $Ca_5(PO_4)_3F:Sn^{2+}$, $\alpha\text{-}Ca_3(PO_4)_2:Eu^{2+}$, $\beta\text{-}Ca_3(PO_4)_2:Eu^{2+}$, $Ca_2P_2O_7:Eu^{2+}$, $Ca_2P_2O_7:Eu^{2+},Mn^{2+}$, $CaP_2O_6:Mn^{2+}$, $\alpha\text{-}Ca_3(PO_4)_2:Pb^{2+}$, $\alpha\text{-}Ca_3(PO_4)_2:Sn^{2+}$, $\beta\text{-}Ca_3(PO_4)_2:Sn^{2+}$, $\beta\text{-}Ca_2P_2O_7:Sn,Mn$, $\alpha\text{-}Ca_3(PO_4)_2:Tr$, $CaS:Bi^{3+}$, $CaS:Bi^{3+},Na$, $CaS:Ce^{3+}$, $CaS:Eu^{2+}$, $CaS:Cu^+,Na^+$, $CaS:La^{3+}$, $CaS:Mn^{2+}$, $CaSO_4:Bi$, $CaSO_4:Ce^{3+}$, $CaSO_4:Ce^{3+},Mn^{2+}$, $CaSO_4:Eu^{2+}$, $CaSO_4:Eu^{2+},Mn^{2+}$, $CaSO_4:Pb^{2+}$, $CaS:Pb^{2+}$, $CaS:Pb^{2+},Cl$, $CaS:Pb^{2+},Mn^{2+}$, $CaS:Pr^{3+},Pb^{2+},Cl$, $CaS:Sb^{3+}$, $CaS:Sb^{3+},Na$, $CaS:Sm^{3+}$, $CaS:Sn^{2+}$, $CaS:Sn^{2+},F$, $CaS:Tb^{3+}$, $CaS:Tb^{3+},Cl$, $CaS:Y^{3+}$, $CaS:Yb^{2+}$, $CaS:Yb^{2+},Cl$, $CaSc_2O_4:Ce$, $Ca_3(Sc,Mg)_2Si_3O_{12}:Ce$, $CaSiO_3:Ce^{3+}$, $Ca_3SiO_4Cl_2:Eu^{2+}$, $Ca_3SiO_4Cl_2:Pb^{2+}$, $CaSiO_3:Eu^{2+}$, $Ca_3SiO_5:Eu^{2+}$, $(Ca,Sr)_3SiO_5:Eu^{2+}$, $(Ca,Sr)_3MgSi_2O_8:Eu^{2+}$, $(Ca,Sr)_3MgSi_2O_8:Eu^{2+},Mn^{2+}$, $CaSiO_3:Mn^{2+},Pb$, $CaSiO_3:Pb^{2+}$, $CaSiO_3:Pb^{2+},Mn^{2+}$, $CaSiO_3:Ti^{4+}$, $CaSr_2(PO_4)_2:Bi^{3+}$, $\beta\text{-}(Ca,Sr)_3(PO_4)_2:Sn^{2+}Mn^{2+}$, $CaTi_{0.9}Al_{0.1}O_3:Bi^{3+}$, $CaTiO_3:Eu^{3+}$, $CaTiO_3:Pr^{3+}$, $Ca_5(VO_4)_3Cl$, $CaWO_4$, $CaWO_4:Pb^{2+}$, $CaWO_4:W$, $Ca_3WO_6:U$, $CaYAlO_4:Eu^{2+}$, $CaYBO_4:Bi^{3+}$, $CaYBO_4:Eu^{3+}$, $CaYB_{0.8}O_{3.7}:Eu^{3+}$, $CaY_2ZrO_6:Eu^{3+}$, $(Ca,Zn,Mg)_3(PO_4)_2:Sn$, $(Ce,Mg)BaAl_{11}O_{18}:Ce$, $(Ce,Mg)SrAl_{11}O_{18}:Ce$,

$CeMgAl_{11}O_{19}:Ce,Tb$, $Cd_2B_6O_{11}:Mn^{2+}$, $CdS:Ag^+,Cr$, $CdS:In$, $CdS:In$, $CdS:In,Te$, $CdS:Te$, $CdWO_4$, $CsF$, $CsI$, $CsI:Na^+$, $CsI:Tl$, $(ErCl_3)_{0.25}(BaCl_2)_{0.75}$, $GaN:Zn$, $Gd_3Ga_5O_{12}:Cr^{3+}$, $Gd_3Ga_5O_{12}:Cr,Ce$, $GdNbO_4:Bi^{3+}$, $Gd_2O_2S:Eu^{3+}$, $Gd_2O_2Pr^{3+}$, $Gd_2O_2S:Pr,Ce,F$, $Gd_2O_2S:Tb^{3+}$, $Gd_2SiO_5:Ce^{3+}$, $KAl_{11}O_{17}:Tl^+$, $KGa_{11}O_{17}:Mn^{2+}$, $K_2La_2Ti_3O_{10}:Eu$, $KMgF_3:Eu^{2+}$, $KMgF_3:Mn^{2+}$, $K_2SiF_6:Mn^{4+}$, $LaAl_3B_4O_{12}:Eu^{3+}$, $LaAlB_2O_6:Eu^{3+}$, $LaAlO_3:Eu^{3+}$, $LaAlO_3:Sm^{3+}$, $LaAsO_4:Eu^{3+}$, $LaBr_3:Ce^{3+}$, $LaBO_3:Eu^{3+}$, $LaCl_3:Ce^{3+}$, $La_2O_3:Bi^{3+}$, $LaOBr:Tb^{3+}$, $LaOBr:Tm^{3+}$, $LaOCl:Bi^{3+}$, $LaOCl:Eu^{3+}$, $LaOF:Eu^{3+}$, $La_2O_3:Eu^{3+}$, $La_2O_3:Pr^{3+}$, $La_2O_2S:Tb^{3+}$, $LaPO_4:Ce^{3+}$, $LaPO_4:Eu^{3+}$, $LaSiO_3Cl:Ce^{3+}$, $LaSiO_3Cl:Ce^{3+},Tb^{3+}$, $LaVO_4:Eu^{3+}$, $La_2W_3O_{12}:Eu^{3+}$, $LiAlF_4:Mn^{2+}$, $LiAl_5O_8:Fe^{3+}$, $LiAlO_2:Fe^{3+}$, $LiAlO_2:Mn^{2+}$, $LiAl_5O_8:Mn^{2+}$, $Li_2CaP_2O_7:Ce^{3+},Mn^{2+}$, $LiCeBa_4Si_4O_{14}:Mn^{2+}$, $LiCeSrBa_3Si_4O_{14}:Mn^{2+}$, $LiInO_2:Eu^{3+}$, $LiInO_2:Sm^{3+}$, $LiLaO_2:Eu^{3+}$, $LuAlO_3:Ce^{3+}$, $(Lu,Gd)_2SiO_5:Ce^{3+}$, $Lu_2SiO_5:Ce^{3+}$, $Lu_2Si_2O_7:Ce^{3+}$, $LuTaO_4:Nb^{5+}$, $Lu_{1-x}Y_xAlO_3:Ce^{3+}$ (mit $0 \leq x \leq 1$), $(Lu,Y)_3(Al,Ga,Sc)_5O_{12}:Ce$, $MgAl_2O_4:Mn^{2+}$, $MgSrAl_{10}O_{17}:Ce$, $MgB_2O_4:Mn^{2+}$, $MgBa_2(PO_4)_2:Sn^{2+}$, $MgBa_2(PO_4)_2:U$, $MgBaP_2O_7:Eu^{2+}$, $MgBaP_2O_7:Eu^{2+},Mn^{2+}$, $MgBa_3Si_2O_8:Eu^{2+}$, $MgBa(SO_4)_2:Eu^{2+}$, $Mg_3Ca(PO_4)_4:Eu^{2+}$, $MgCaP_2O_7:Mn^{2+}$, $Mg_2Ca(SO_4)_3:Eu^{2+}$, $Mg_2Ca(SO_4)_3:Eu^{2+},Mn2$, $MgCeAl_nO_{19}:Tb^{3+}$, $Mg_4(F)GeO_6:Mn^{2+}$, $Mg_4(F)(Ge,Sn)O_6:Mn^{2+}$, $MgF_2:Mn^{2+}$, $MgGa_2O_4:Mn^{2+}$, $Mg_8Ge_2O_{11}F_2:Mn^{4+}$, $MgS:Eu^{2+}$, $MgSiO_3:Mn^{2+}$, $Mg_2SiO_4:Mn^{2+}$, $Mg_3SiO_3F_4:Ti^{4+}$, $MgSO_4:Eu^{2+}$, $MgSO_4:Pb^{2+}$, $MgSrBa_2Si_2O_7:Eu^{2+}$, $MgSrP_2O_7:Eu^{2+}$, $MgSr_5(PO_4)_4:Sn^{2+}$, $MgSr_3Si_2O_8:Eu^{2+},Mn^{2+}$, $Mg_2Sr(SO_4)_3:Eu^{2+}$, $Mg_2TiO_4:Mn^{4+}$, $MgWO_4$, $MgYBO_4:Eu^{3+}$, $M_2MgSi_2O_7:Eu^{2+}$ (M = Ca, Sr, und/oder Ba), $M_2MgSi_2O_7:Eu^{2+},Mn^{2+}$ (M = Ca, Sr, und/oder Ba), $M_2MgSi_2O_7:Eu^{2+},Zr^{4+}$ (M = Ca, Sr, und/oder Ba), $M_2MgSi_2O_7:Eu^{2+},Mn^{2+},Zr^{4+}$ (M = Ca, Sr, und/oder Ba), $Na_3Ce(PO_4)_2:Tb^{3+}$, $Na_{1.23}K_{0.42}Eu_{0.12}TiSi_4O_{11}:Eu^{3+}$, $Na_{1.23}K_{0.42}Eu_{0.12}TiSi_5O_{13}\cdot xH_2O:Eu^{3+}$, $Na_{1.29}K_{0.46}Er_{0.08}TiSi_4O_{11}:Eu^{3+}$, $Na_2Mg_3Al_2Si_2O_{10}:Tb$, $Na(Mg_{2-x}Mn_x)LiSi_4O_{10}F_2:Mn$ (mit $0 \leq x \leq 2$), $NaYF_4:Er^{3+},Yb^{3+}$, $NaYO_2:Eu^{3+}$, P46 (70%) + P47 (30%), ß-SiAlON:Eu, $SrAl_{12}O_{19}:Ce^{3+},Mn^{2+}$, $SrAl_2O_4:Eu^{2+}$, $SrAl_4O_7:Eu^{3+}$, $SrAl_{12}O_{19}:Eu^{2+}$, $SrAl_2S_4:Eu^{2+}$, $Sr_2B_5O_9Cl:Eu^{2+}$, $SrB_4O_7:Eu^{2+}(F,Cl,Br)$, $SrB_4O_7:Pb^{2+}$, $SrB_4O_7:Pb^{2+},Mn^{2+}$, $SrB_8O_{13}:Sm^{2+}$, $Sr_xBa_yCl_zAl_2O_{4-z/2}:Mn^{2+},Ce^{3+}$, $SrBaSiO_4:Eu^{2+}$, $(Sr,Ba)_3SiO_5:Eu$, $(Sr,Ca)Si_2N_2O_2:Eu$, $Sr(Cl,Br,I)_2:Eu^{2+}$ in $SiO_2$, $SrCl_2:Eu^{2+}$ in $SiO_2$, $Sr_5Cl(PO_4)_3:Eu$, $Sr_wF_xB_4O_{6.5}:Eu^{2+}$, $Sr_wF_xB_yO_z:Eu^{2+},Sm^{2+}$, $SrF_2:Eu^{2+}$, $SrGa_{12}O_{19}:Mn^{2+}$, $SrGa_2S_4:Ce^{3+}$, $SrGa_2S_4:Eu^{2+}$, $Sr_{2-y}Ba_ySiO_4:Eu$ (wobei $0 \leq y \leq 2$), $SrSi_2O_2N_2:Eu$, $SrGa_2S_4:Pb^{2+}$, $SrIn_2O_4:Pr^{3+},Al^{3+}$, $(Sr,Mg)_3(PO_4)_2:Sn$, $SrMgSi_2O_6:Eu^{2+}$, $Sr_2MgSi_2O_7:Eu^{2+}$, $Sr_3MgSi_2O_8:Eu^{2+}$, $SrMoO_4:U$, $SrO\cdot 3B_2O_3:Eu^{2+},Cl$, ß-$SrO\cdot 3B_2O_3:Pb^{2+}$, ß-$SrO\cdot 3B_2O_3:Pb^{2+},Mn^{2+}$, α-$SrO\cdot 3B_2O_3:Sm^{2+}$, $Sr_6P_5BO_{20}:Eu$, $Sr_5(PO_4)_3Cl:Eu^{2+}$, $Sr_5(PO_4)_3Cl:Eu^{2+},Pr^{3+}$, $Sr_5(PO_4)_3Cl:Mn^{2+}$, $Sr_5(PO_4)_3Cl:Sb^{3+}$, $Sr_2P_2O_7:Eu^{2+}$, β-$Sr_3(PO_4)_2:Eu^{2+}$, $Sr_5(PO_4)_3F:Mn^{2+}$, $Sr_5(PO_4)_3F:Sb^{3+}$, $Sr_5(PO_4)_3F:Sb^{3+},Mn^{2+}$, $Sr_5(PO_4)_3F:Sn^{2+}$, $Sr_2P_2O_7:Sn^{2+}$, β-$Sr_3(PO_4)_2:Sn^{2+}$, β-$Sr_3(PO_4)_2:Sn^{2+},Mn^{2+}(Al)$, $SrS:Ce^{3+}$, $SrS:Eu^{2+}$, $SrS:Mn^{2+}$, $SrS:Cu^+,Na$, $SrSO_4:Bi$, $SrSO_4:Ce^{3+}$, $SrSO_4:Eu^{2+}$, $SrSO_4:Eu^{2+},Mn^{2+}$, $Sr_5Si_4O_{10}Cl_6:Eu^{2+}$, $Sr_2SiO_4:Eu^{2+}$, $Sr_3SiO_5:Eu^{2+}$, $(Sr,Ba)_3SiO_5:Eu^{2+}$, $SrTiO_3:Pr^{3+}$, $SrTiO_3:Pr^{3+},Al^{3+}$, $SrY_2O_3:Eu^{3+}$, $ThO_2:Eu^{3+}$, $ThO_2:Pr^{3+}$, $ThO_2:Tb^{3+}$, $YAl_3B_4O_{12}:Bi^{3+}$, $YAl_3B_4O_{12}:Ce^{3+}$, $YAl_3B_4O_{12}:Ce^{3+},Mn$, $YAl_3B_4O_{12}:Ce^{3+},Tb^{3+}$, $YAl_3B_4O_{12}:Eu^{3+}$, $YAl_3B_4O_{12}:Eu^{3+},Cr^{3+}$, $YAl_3B_4O_{12}:Th^{4+},Ce^{3+},Mn^{2+}$, $YAlO_3:Ce^{3+}$, $Y_3Al_5O_{12}:Ce^{3+}$, $Y_3Al_5O_{12}:Cr^{3+}$, $YAlO_3:Eu^{3+}$, $Y_3Al_5O_{12}:Eu^{3r}$, $Y_4Al_2O_9:Eu^{3+}$, $Y_3Al_5O_{12}:Mn^{4+}$, $YAlO_3:Sm^{3+}$, $YAlO_3:Tb^{3+}$, $Y_3Al_5O_{12}:Tb^{3+}$, $YAsO_4:Eu^{3+}$, $YBO_3:Ce^{3+}$, $YBO_3:Eu^{3+}$, $YF_3:Er^{3+},Yb^{3+}$, $YF_3:Mn^{2+}$, $YF_3:Mn^{2+},Th^{4+}$, $YF_3:Tm^{3+},Yb^{3+}$, $(Y,Gd)BO_3:Eu$, $(Y,Gd)BO_3:Tb$, $(Y,Gd)_2O_3:Eu^{3+}$, $Y_{1.34}Gd_{0.60}O_3:(Eu,Pr)$, $Y_2O_3:Bi^{3+}$, $YOBr:Eu^{3+}$, $Y_2O_3:Ce$, $Y_2O_3:Er^{3+}$, $Y_2O_3:Eu^{3+}$, $Y_2O_3:Ce^{3+},Tb^{3+}$, $YOCl:Ce^{3+}$, $YOCl:Eu^{3+}$, $YOF:Eu^{3+}$, $YOF:Tb^{3+}$, $Y_2O_3:HO^{3+}$, $Y_2O_2S:Eu^{3+}$, $Y_2O_2S:Pr^{3+}$, $Y_2O_2S:Tb^{3+}$, $Y_2O_3:Tb^{3+}$, $YPO_4:Ce^{3+}$, $YPO_4:Ce^{3+},Tb^{3+}$, $YPO_4:Eu^{3+}$, $YPO_4:Mn^{2+},Th^{4+}$, $YPO_4:V^{5+}$, $Y(P,V)O_4:Eu$, $Y_2SiO_5:Ce^{3+}$, $YTaO_4$, $YTaO_4:Nb^{5+}$, $YVO_4:Dy^{3+}$, $YVO_4:Eu^{3+}$, $ZnAl_2O_4:Mn^{2+}$, $ZnB_2O_4:Mn^{2+}$, $ZnBa_2S_3:Mn^{2+}$, $(Zn,Be)_2SiO_4:Mn^{2+}$, $Zn_{0.4}Cd_{0.6}S:Ag$, $Zn_{0.6}Cd_{0.4}S:Ag$, $(Zn,Cd)S:Ag,Gl$, $(Zn,Cd)S:Cu$, $ZnF_2:Mn^{2+}$, $ZnGa_2O_4$, $ZnGa_2O_4:Mn^{2+}$, $ZnGa_2S_4:Mn^{2+}$, $Zn_2GeO_4:Mn^{2+}$, $(Zn,Mg)F_2:Mn^{2+}$, $ZnMg_2(PO_4)_2:Mn^{2+}$, $(Zn,Mg)_3(PO_4)_2:Mn^{2+}$, $ZnO:Al^{3+},Ga^{3+}$, $ZnO:Bi^{3+}$, $ZnO:Ga^{3+}$, $ZnO:Ga$, $ZnO\text{-}CdO:Ga$, $ZnO:S$, $ZnO:Se$, $ZnO:Zn$, $ZnS:Ag^+,Cl^-$, $ZnS:Ag,Cu,Cl$, $ZnS:Ag,Ni$, $ZnS:Au,In$, $ZnS\text{-}CdS$ (25-75), $ZnS\text{-}CdS$ (50-50), $ZnS\text{-}CdS$ (75-25), $ZnS\text{-}CdS:Ag,Br,Ni$, $ZnS\text{-}CdS:Ag^+,Cl$, $ZnS\text{-}CdS:Cu,Br$, $ZnS\text{-}CdS:Cu,I$, $ZnS:Cl^-$, $ZnS:Eu^{2+}$, $ZnS:Cu$, $ZnS:Cu^+,Al^{3+}$, $ZnS:Cu^+,Cl^-$, $ZnS:Cu,Sn$, $ZnS:Eu^{2+}$, $ZnS:Mn^{2+}$, $ZnS:Mn,Cu$, $ZnS:Mn^{2+},Te^{2+}$, $ZnS:P$, $ZnS:P^{3-},Cl^-$, $ZnS:Pb^{2+}$, $ZnS:Pb^{2+},Cl^-$, $ZnS:Pb,Cu$, $Zn_3(PO_4)_2:Mn^{2+}$, $Zn_2SiO_4:Mn^{2+}$, $Zn_2SiO_4:Mn^{2+},As^{5+}$, $Zn_2SiO_4:Mn,Sb_2O_2$, $Zn_2SiO_4:Mn^{2+},P$, $Zn_2SiO_4:Ti^{4+}$, $ZnS:Sn^{2+}$, $ZnS:Sn,Ag$, $ZnS:Sn^{2+},Li^+$, $ZnS:Te,Mn$, $ZnS\text{-}ZnTe:Mn^{2+}$, $ZnSe:Cu^+,Cl$ und $ZnWO_4$.

Dabei zeigen die offenbarten Verbindungen insbesondere Vorteile bei der Mischung mit weiteren Leuchtstoffen anderer Fluoreszenzfarben bzw. beim Einsatz in LEDs gemeinsam mit solchen Leuchtstoffen. Bevorzugt werden die offenbarten Verbindungen zusammen mit grün emittierenden Leuchtstoffen eingesetzt. Es hat sich gezeigt, dass insbesondere bei Kombination der offenbarten Verbindungen mit grün emittierenden Leuchtstoffen die Optimierung von Beleuchtungsparametern für weiße LEDs besonders gut gelingt.

Entsprechende grün emittierende Leuchtstoffe sind dem Fachmann bekannt bzw. kann der Fachmann aus der oben aufgeführten Liste auswählen. Besonders geeignete grün emittierende Leuchtstoffe sind dabei $(Sr,Ba)_2SiO_4:Eu$, $(Sr,Ba)_3SiO_5:Eu$, $(Sr,Ca)Si_2N_2O_2:Eu$, $BaSi_2N_2O_2:Eu$, $(Lu,Y)_3(Al,Ga,Sc)_5O_{12}:Ce$, β-SiAlON:Eu, $CaSc_2O_4:Ce$, $CaSc_2O_4:Ce,Mg$, $Ba_3Si_6O_{12}N_2:Eu$ und $Ca_3(Sc,Mg)_2S_{13}O_{12}:Ce$. Besonders bevorzugt sind $Ba_3Si_6O_{12}N_2:Eu$ und $Ca_3(Sc,Mg)_2S_{13}O_{12}:Ce$.

In einer weiteren bevorzugten Ausführungsform der Erfindung ist es bevorzugt, die offenbarte Verbindung als einzigen Leuchtstoff zu verwenden. Die offenbarte Verbindung zeigt durch das breite Emissionsspektrum mit hohem Rotanteil auch bei Verwendung als Einzelleuchtstoff sehr gute Ergebnisse.

Bevorzugte Quantenmaterialien, die zusammen mit dem offenbarten Lumineszenzmaterial eingesetzt werden können und die strahlungskonvertierende Mischung bilden, unterliegen keiner besonderen Einschränkung. Es kann daher generell jedes mögliche Quantenmaterial verwendet werden. Dabei eignen sich insbesondere Halbleiter-Nanopartikel mit länglicher, runder, elliptischer und pyramidaler Geometrie, die in einer Kern-Schale-Konfiguration oder in einer Kern-Mehrschale-Konfiguration vorliegen können. Solche Halbleiter-Nanopartikel sind beispielsweise aus der WO 2005075339, WO 2006134599, EP 2 528 989 B1 und US 8,062,421 B2 bekannt, deren Offenbarungen hiermit durch Bezugnahme eingefügt werden.

Die Quantenmaterialien bestehen vorzugsweise aus Halbleitern der Gruppen II-VI, III-V, IV-VI oder I-III-VI$_2$ oder einer beliebigen Kombination davon. Beispielsweise kann das Quantenmaterial ausgewählt sein aus der Gruppe bestehend aus CdS, CdSe, CdTe, ZnS, ZnSe, ZnTe, ZnO, GaAs, GaP, GaAs, GaSb, GaN, HgS, HgSe, HgTe, InAs, InP, InSb, AlAs, AlP, AlSb, $Cu_2S$, $Cu_2Se$, $CuGaS_2$, $CuGaSe_2$, $CuInS_2$, $CuInSe_2$, $Cu_2(InGa)S_4$, $AgInS_2$, $AgInSe_2$, $Cu_2(ZnSn)S_4$, Legierungen davon und Mischungen daraus.

Quantenmaterialien können auch in der Form von Halbleiter-Nanopartikeln auf der Oberfläche von nicht aktivierten kristallinen Materialien vorliegen. In solchen Materialien befinden sich eine oder mehrere Arten von Halbleiter-Nanopartikeln auf der Oberfläche von einer oder mehreren Arten von nicht aktivierten kristallinen Materialien, wie z.B. nichtaktivierten Leuchtstoffmatrixmaterialien. Solche Materialien werden auch als Quantenmaterial auf Phosphormatrix (QMOP) bezeichnet und sind aus WO 2017/041875 A1 bekannt, deren Offenbarung hiermit durch Bezugnahme eingefügt wird.

In nochmals einer weiteren Ausführungsform der Erfindung ist es bevorzugt, wenn die Leuchtstoffe so auf der Primärlichtquelle angeordnet sind, dass der rot emittierende Leuchtstoff im Wesentlichen von dem Licht der Primärlichtquelle angestrahlt wird, während der grün emittierende Leuchtstoff im Wesentlichen von dem Licht angestrahlt wird, das bereits den rot emittierenden Leuchtstoff passiert hat bzw. von diesem gestreut wurde. Dies kann realisiert werden, indem der rot emittierende Leuchtstoff zwischen der Primärlichtquelle und dem grün emittierenden Leuchtstoff angebracht wird.

Die offenbarten Leuchtstoffe bzw. Leuchtstoffkombinationen können als Schüttgut, Pulvermaterial, dickes oder dünnes Schichtmaterial oder selbstragendes Material, vorzugsweise in Form eines Films vorliegen. Ferner kann es in einem Vergussmaterial eingebettet sein.

Die offenbarten Leuchtstoffe bzw. Leuchtstoffkombinationen können hierbei entweder in einem Vergussmaterial dispergiert, oder bei geeigneten Größenverhältnissen direkt auf der Primärlichtquelle angeordnet werden oder aber von dieser, je nach Anwendung, entfernt angeordnet sein (letztere Anordnung schließt auch die "Remote Phosphor Technologie" mit ein). Die Vorteile der "Remote Phosphor Technologie" sind dem Fachmann bekannt und z.B. der folgenden Publikation zu entnehmen: Japanese Journal of Applied Physics Vol. 44, No. 21 (2005), L649-L651.

Der Begriff "Vergussmaterial" bezieht sich auf ein lichtdurchlässiges Matrixmaterial, das die offenbarten Lumineszenzmaterialien und strahlungskonvertierenden Mischungen einschließt. Das lichtdurchlässige Matrixmaterial kann aus einem Silicon, einem Polymer (das aus einem flüssigen oder halbfesten Vorläufermaterial, wie einem Monomer oder Oligomer, gebildet wird), einem Epoxid, einem Glas oder einem Hybrid aus einem Silicon und einem Epoxid gebildet sein. Spezifische, jedoch nicht einschränkende Beispiele der Polymere beinhalten fluorierte Polymere, Polyacrylamid-Polymere, Polyacrylsäure-Polymere, Polyacrylnitril-Polymere, Polyanilin-Polymere, Polybenzophenon-Polymere, Poly(methylmethacrylat)-Polymere, Silicon-Polymere, Aluminium-Polymere, Polybispheno-Polymere, Polybutadien-Polymere, Polydimethylsiloxan-Polymere, Polyethylen-Polymere, Polyisobutylen-Polymere, Polypropylen-Polymere, Polystyrol-Polymere, Polyvinyl-Polymere, Polyvinylbutyral-Polymere oder Perfluorcyclobutyl-Polymere. Silicone können Gele, wie beispielsweise Dow Corning® OE-6450, Elastomere, wie beispielsweise Dow Corning® OE-6520, Dow Corning® OE-6550, Dow Corning® OE-6630, und Harze, wie beispielsweise Dow Corning® OE-6635, Dow Corning® OE-6665, Nusil LS-6143 und andere Produkte von Nusil, Momentive RTV615, Momentive RTV656 und viele andere Produkte von anderen Herstellern, einschließen. Ferner kann das Vergussmaterial ein (Poly)silazan, wie beispielsweise ein modifiziertes organisches Polysilazan (MOPS) oder ein Perhydropolysilazan (PHPS) sein. Der Anteil des Lumineszenzmaterials bzw. der strahlungskonvertierenden Mischung, bezogen auf das Vergussmaterial, liegt vorzugsweise im Bereich von 1 bis 300 Gew.-%, stärker bevorzugt im Bereich von 3 bis 50 Gew.-%.

In einer weiteren Ausführungsform ist es bevorzugt, wenn die optische Ankopplung zwischen dem Lumineszenzmaterial und der Primärlichtquelle durch eine lichtleitende Anordnung realisiert wird. Dadurch ist es möglich, dass an einem zentralen Ort die Primärlichtquelle installiert wird und diese mittels lichtleitender Vorrichtungen, wie beispielsweise lichtleitenden Fasern, an das Lumineszenzmaterial optisch angekoppelt ist. Auf diese Weise ist es möglich, eine starke Primärlichtquelle an einen für die elektrische Installation günstigen Ort zu platzieren und ohne weitere elektrische Verkabelung, sondern nur durch Verlegen von Lichtleitern an beliebigen Orten Leuchten mit Lumineszenzmaterialien, welche an die Lichtleiter optisch gekoppelt sind, zu installieren.

Darüber hinaus kann der offenbarte Leuchtstoff oder die strahlungskonvertierende Mischung in einer Filament-LED eingesetzt werden, wie beispielsweise in US 2014/0369036 A1 beschrieben.

Weitere Erfindungsgegenstände sind eine Beleuchtungseinheit, insbesondere zur Hintergrundbeleuchtung von Anzeigevorrichtungen, dadurch gekennzeichnet, dass sie mindestens eine erfindungsgemäße Lichtquelle enthält, sowie eine Anzeigevorrichtung, insbesondere Flüssigkristallanzeigevorrichtung (LC Display), mit einer Hintergrundbeleuchtung, dadurch gekennzeichnet, dass sie mindestens eine offenbarte Beleuchtungseinheit enthält.

Die mittlere Partikelgröße der offenbarten Leuchtstoffe beträgt für den Einsatz in LEDs üblicherweise zwischen 50 nm und 30 $\mu$m, vorzugsweise zwischen 0,1 $\mu$m und 25 $\mu$m und stärker bevorzugt zwischen 1 $\mu$m und 20 $\mu$m. Die mittlere Partikelgröße wird vorzugsweise gemäß ISO 13320:2009 ("Particle size analysis - laser diffracation methods") ermittelt. Die ISO-Norm basiert auf der Messung der Größenverteilung von Partikeln durch Analyse ihrer Lichtstreuungseigenschaften.

Zum Einsatz in LEDs können die Leuchtstoffe auch in beliebige äußere Formen, wie sphärische Partikel, Plättchen und strukturierte Materialien und Keramiken, überführt werden. Diese Formen werden erfindungsgemäß unter dem Begriff "Formkörper" zusammengefasst. Vorzugsweise handelt es sich bei dem Formkörper um einen "Leuchtstoffkörper". Ein weiterer Gegenstand der vorliegenden Erfindung ist somit ein Formkörper enthaltend die erfindungsgemäßen Leuchtstoffe. Die Herstellung und Verwendung entsprechender Formkörper ist dem Fachmann aus zahlreichen Publikationen geläufig.

Die offenbarten Verbindungen weisen die folgenden vorteilhaften Eigenschaften auf:

1) Die offenbarten Verbindungen besitzen ein Emissionsspektrum mit hohem Rotanteil und sie weisen eine hohe Photolumineszenz-Quantenausbeute auf.

2) Die offenbarten Verbindungen weisen eine geringe thermische Löschung auf. So liegen die $TQ_{1/2}$-Werte der erfindungsgemäßen Verbindungen üblicherweise im Bereich von über 400 K.

3) Die hohe Temperaturstabilität der offenbarten Verbindungen ermöglicht die Anwendung des Materials auch in thermisch hochbelasteten Lichtquellen.

4) Ferner zeichnen sich die offenbarten Verbindungen durch eine hohe Lebensdauer aus und ermöglichen eine hohe Farbwiedergabe und hohe Stabilität der Farbtemperatur in einer LED. Hierdurch können warm-weiße pc-LEDs mit hohen Farbwiedergabewerten bei niedrigen Farbtemperaturen (CCT < 4000 K) realisiert werden.

5) Die offenbarten Verbindungen lassen sich über eine einfache Synthese effizient und kostengünstig herstellen.

Alle hier beschriebenen Ausführungsformen können miteinander kombiniert werden, sofern sich die jeweiligen Ausführungsformen nicht gegenseitig ausschließen. Insbesondere ist es ausgehend von der Lehre dieser Schrift im Rahmen des routinemäßigen Optimierens ein naheliegender Vorgang, gerade verschiedene hier beschriebene Ausführungsformen zu kombinieren, um zu einer konkreten besonders bevorzugten Ausführungsform zu gelangen.

Die folgenden Beispiele sollen die vorliegende Erfindung verdeutlichen und zeigen insbesondere das Ergebnis exemplarischer Kombinationen der beschriebenen Ausführungsformen der Erfindung. Sie sind jedoch keinesfalls als einschränkend zu betrachten, sondern sollen vielmehr zur Verallgemeinerung anregen. Alle Verbindungen oder Komponenten, die bei der Herstellung verwendet werden, sind entweder bekannt und käuflich erhältlich oder können nach bekannten Methoden synthetisiert werden. Die in den Beispielen angegebenen Temperaturen gelten immer in °C. Es versteht sich weiterhin von selbst, dass sich sowohl in der Beschreibung als auch in den Beispielen die verwendeten Mengen der Bestandteile in den Zusammensetzungen immer zu insgesamt 100% addieren. Prozentangaben sind immer im gegebenen Zusammenhang zu sehen.

**Beispiele**

**Messmethoden**

Die Emissionsspektren wurden mit einem Fluoreszenzspektrometer der Firma Edinburgh Instruments Ltd., ausgestattet mit einer Spiegeloptik für Pulverproben, bei einer Anregungswellenlänge von 450 nm aufgenommen. Als Anregungsquelle wurde eine 450 W Xe-Lampe verwendet. Zur temperaturabhängigen Messung der Emission wurde das Spektrometer mit einem Kryostat der Firma Oxford Instruments ausgestattet (MicrostatN2). Als Kühlmittel wurde Stickstoff eingesetzt.

Reflexionsspektren wurden mit einem Fluoreszenzspektrometer der Firma Edinburgh Instruments Ltd. bestimmt. Dafür wurden die Proben in eine mit $BaSO_4$ beschichtete Ulbricht-Kugel platziert und vermessen. Reflexionsspektren wurden in einem Bereich von 250 bis 800 nm aufgenommen. Als Weißstandard wurde $BaSO_4$ (Alfa Aesar 99,998 %) verwendet. Eine 450 W Xe-Hochdrucklampe diente als Anregungsquelle.

Die Anregungsspektren wurden mit einem Fluoreszenzspektrometer der Firma Edinburgh Instruments Ltd., ausgestattet mit einer Spiegeloptik für Pulverproben, bei 550 nm aufgenommen. Als Anregungsquelle wurde eine 450 W Xe-Lampe verwendet.

Die Röntgendiffraktogramme wurden mit einem Rigaku Miniflex II, betrieben in Bregg-Brentano-Geometrie, in 0,02 ° Schritten bei einer Integrationszeit von 1 s mit Cu $K_{alpha}$-Strahlung aufgenommen.

Die Kristallstrukturanalyse wurde folgendermaßen durchgeführt: Nadelförmig geformte Einkristalle wurden abgetrennt. Die Kristalle wurden mit Bienenwachs auf dünne Quarzfasern geklebt. Die Qualität der Einkristalle für die Intensitätsdatenerfassung wurde durch Laue-Aufnahmen mit einer Buerger-Kamera überprüft (weiße Molybdänröntgenstrahlung, Image-Plate-Technik, Fujifilm, BAS-1800). Die Datensätze wurden auf einem Diffraktometer von Stoe Stadi-Vari gemessen, welches mit einer Mo-Mikrofokusquelle und einem Pilatus-Detektionssystem bei 293 K ausgestattet war. Die Temperaturkontrolle erfolgte über ein Cryostream Plus System (Oxford Cryosystems, 700 Serie) mit einer Genauigkeit von ± 0,5 K. Aufgrund eines Gaußförmigen Profils der Röntgenquelle wurde die Skalierung mit einer numerischen Absorptionskorrektur für alle Datensätze durchgeführt.

Beispiel 1: Darstellung von $HK_3Mo_{0,99}Mn_{0,01}F_{6,02}O_{1,98}$

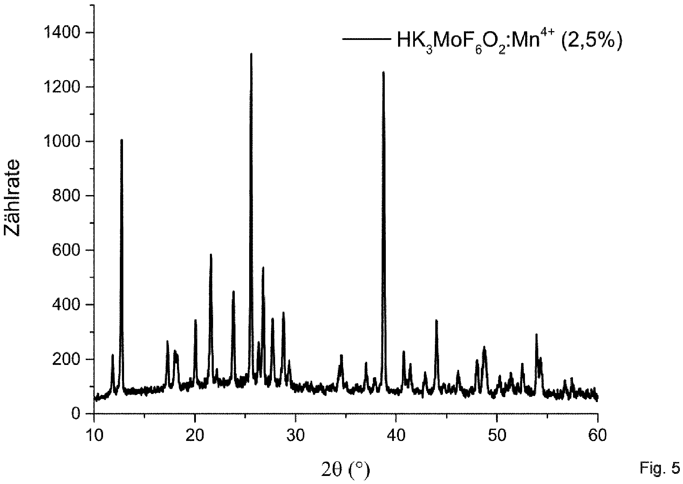

6,69 g (120 mmol) KF, 2,38 g (10,00 mmol) $K_2MoO_4$, und 0,1234 g (0,5 mmol) $K_2MnF_6$ wurden jeweils in 3 ml Flusssäure (48 Gew.-%) gelöst. Unter intensivem Rühren wurde zuerst die KF-Lösung mit der $K_2MnF_6$-Lösung vereint. Danach wurde langsam die $K_2MoO_4$-Lösung zugetropft. Es bildete sich instantan ein gelbes Präzipitat, welches der Zusammensetzung $HK_3Mo_{0,99}Mn_{0,01}F_{6,02}O_{1,98}$ entspricht. Das Pulver wurde abfiltriert und danach mehrmals mit kaltem Aceton (ca. 0 °C) gewaschen. Das erhaltene hellgelbe Pulver wurde im Vakuum für 8 h bei 70 °C getrocknet. Der CIE1931 Farbpunkt liegt bei x = 0,688 und y = 0,312. Das Lumenäquivalent beträgt 231 lm/W$_{opt}$. Figur 5 zeigt ein Röntgenpulverdiffraktogramm der hergestellten Verbindung.

Beispiel 2: Darstellung von $HK_3W_{0,99}Mn_{0,01}F_{6,02}O_{1,98}$

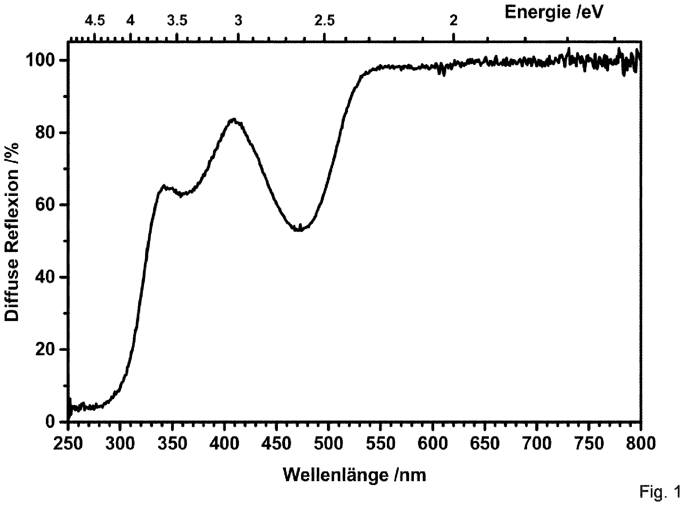

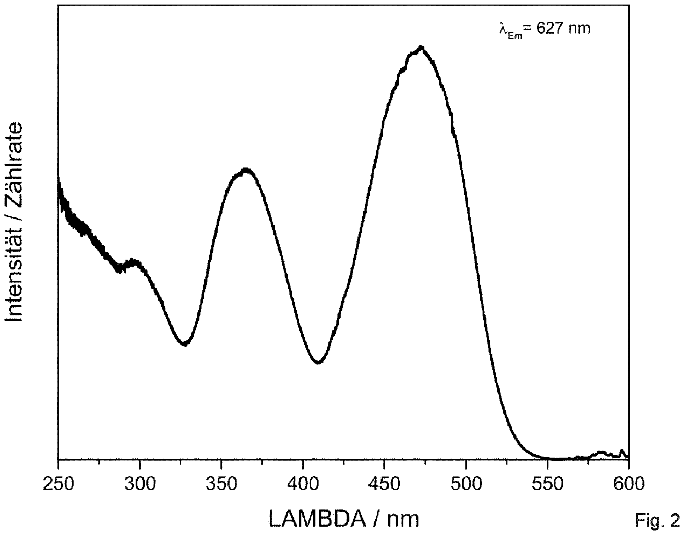

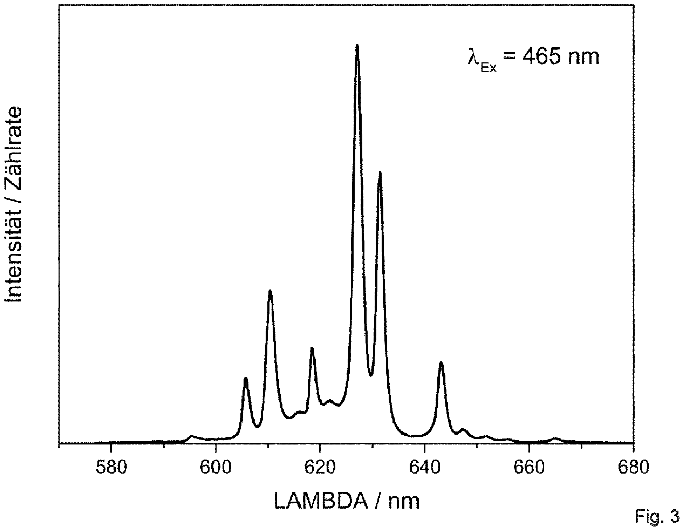

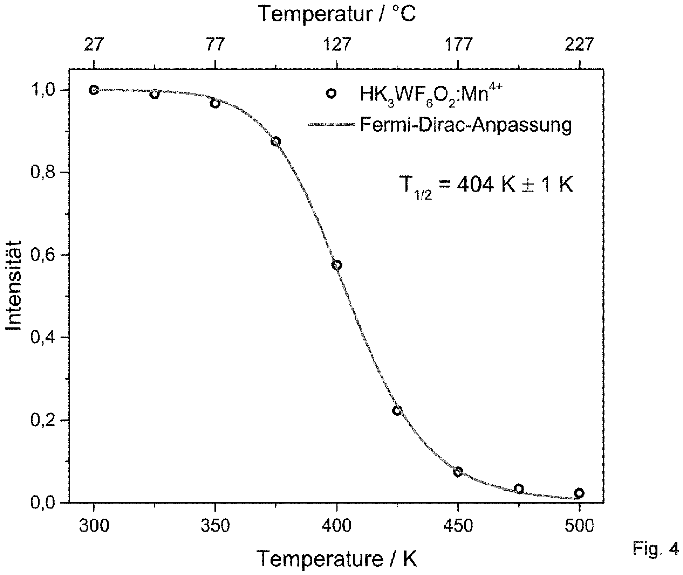

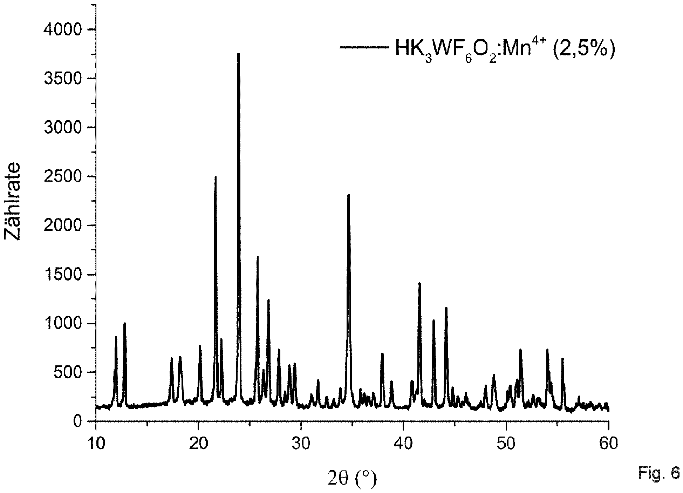

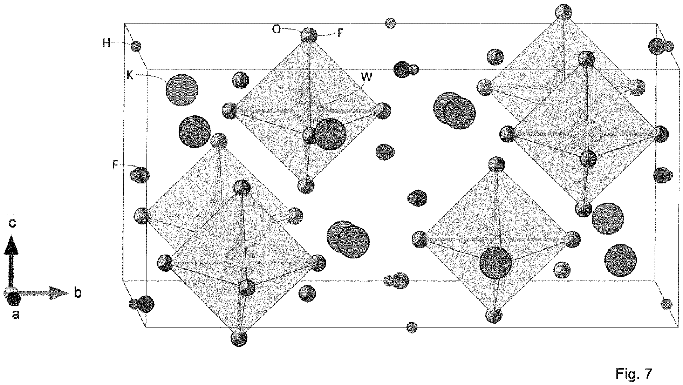

6,69 g (120 mmol) KF, 3,26 g (10,00 mmol) $K_2WO_4$, und 0,1234 g (0,5 mmol) $K_2MnF_6$ wurden jeweils in 3 ml Flusssäure (48 wt-%) gelöst. Unter intensivem Rühren wurde zuerst die KF-Lösung mit der $K_2MnF_6$-Lösung vereint. Danach wurde langsam die $K_2WO_4$-Lösung zugetropft. Es bildete sich instantan ein gelbes Präzipitat, welches der Zusammensetzung $HK_3W_{0,99}Mn_{0,01}F_{6,02}O_{1,98}$ entspricht. Das Pulver wurde abfiltriert und danach mehrmals mit kaltem Aceton (ca. 0 °C) gewaschen. Das erhaltene hellgelbe Pulver wurde im Vakuum für 8 h bei 70 °C getrocknet. Der CIE1931 Farbpunkt liegt bei x = 0,688 und y = 0,312. Das Lumenäquivalent beträgt 225 lm/W$_{opt}$. Das Reflexionsspektrum, Anregungsspektrum, Emissionsspektrum sowie die thermische Löschkurve der hergestellten Verbindung sind in den Figuren 1 bis 4 gezeigt. Die Figuren 6 und 7 zeigen ein Röntgenpulverdiffraktogramm sowie eine Darstellung der Kristallstruktur der hergestellten Verbindung.

Beispiel 3: Darstellung von $HK_3Cr_{0,99}Mn_{0,01}F_{6,02}O_{1,98}$

6,69 g (120 mmol) KF, 1,94 g (10,00 mmol) $K_2CrO_4$, und 0,1234 g (0,5 mmol) $K_2MnF_6$ wurden jeweils in 3 ml Flusssäure (48 wt-%) gelöst. Unter intensivem Rühren wurde zuerst die KF-Lösung mit der $K_2MnF_6$-Lösung vereint. Danach wurde langsam die $K_2CrO_4$-Lösung zugetropft. Es bildete sich instantan ein gelbes Präzipitat, welches der Zusammensetzung $HK_3Cr_{0,99}Mn_{0,01}F_{6,02}O_{1,98}$ entspricht. Das Pulver wurde abfiltriert und danach mehrmals mit kaltem Aceton (ca. 0 °C) gewaschen. Das erhaltene hellgelbe Pulver wurde im Vakuum für 8 h bei 70 °C getrocknet. Der CIE1931 Farbpunkt liegt bei x = 0,688 und y = 0,312. Das Lumenäquivalent beträgt 225 lm/W$_{opt}$.

Beispiel 4: Darstellung von $HK_3Re_{0,99}Mn_{0,01}F_{6,02}O_{1,98}$

6,69 g (120 mmol) KF, 1,94 g (10,00 mmol) $KReO_4$, und 0,1234 g (0,5 mmol) $K_2MnF_6$ wurden jeweils in 3 ml Flusssäure (48 wt-%) gelöst. Unter intensivem Rühren wurde zuerst die KF-Lösung mit der $K_2MnF_6$-Lösung vereint. Danach wurde langsam die $KReO_4$-Lösung zugetropft. Es bildete sich instantan ein gelbes Präzipitat, welches der Zusammensetzung $HK_3Re_{0,99}Mn_{0,01}F_{6,02}O_{1,98}$ entspricht. Das Pulver wurde abfiltriert und danach mehrmals mit kaltem Aceton (ca. 0 °C) gewaschen. Das erhaltene hellgelbe Pulver wurde im Vakuum für 8 h bei 70 °C getrocknet. Der CIE1931 Farbpunkt liegt bei x = 0,688 und y = 0,312. Das Lumenäquivalent beträgt 225 lm/W$_{opt}$.

Beispiel 5: Herstellung und Charakterisierung von LEDs unter Verwendung der Lumineszenzmaterialien

Allgemeine Vorschrift zur Herstellung und Messung von pc-LEDs: Eine Masse von $m_{LS}$ (in g) des im jeweiligen LED-Beispiel aufgeführten Lumineszenzmaterials und eine Masse m(YAG:Ce) (erhältlich von Philips, Handelsname: U728) werden abgewogen und mit $m_{Silikon}$ (in g) eines optisch transparenten Silikons versetzt und anschließend in einem Planeten-Zentrifugalmischer homogen vermischt, so dass $c_{LS}$ (in Gew.-%) die Konzentration des Lumineszenzmaterials in der Gesamtmasse angibt. Das so erhaltene Silikon-Lumineszenzmaterial-Gemisch wird mit Hilfe eines automatischen Dispensers auf den Chip einer blauen Halbleiter-LED aufgebracht und unter Wärmezufuhr ausgehärtet. Die in den vorliegenden Beispielen für die LED-Charakterisierung aufgeführte Referenz-LED wurde mit reinem Silikon ohne Lumineszenzmaterial befüllt. Die verwendeten blauen Halbleiter-LEDs weisen eine Emissionswellenlänge von 450 nm auf und werden mit einer Stromstärke von 350 mA betrieben. Die lichttechnische Charakterisierung der LEDs erfolgt mit einem Spektrometer der Fa. Instrument Systems - Spektrometer CAS 140 und einer damit verbundenen Integrationskugel ISP 250. Charakterisiert wird die LED über die Ermittlung der wellenlängenabhängigen spektralen Leistungsdichte. Das so erhaltene Spektrum des von der LED emittierten Lichts wird zur Berechnung der Farbpunktkoordinaten CIE x und y verwendet.

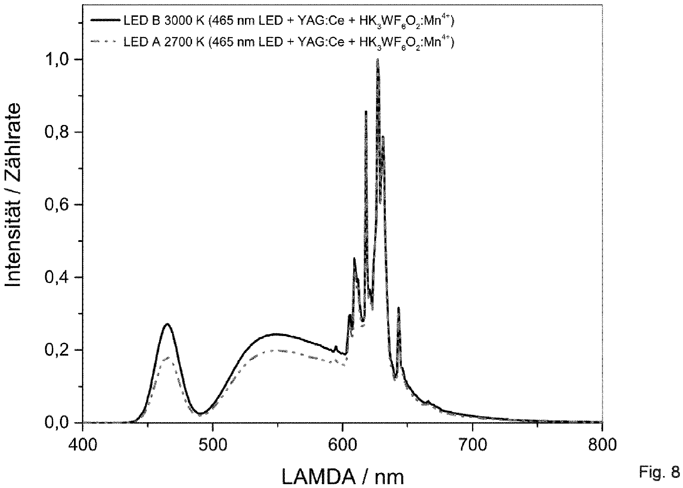

Die Einwaagen der im jeweiligen Beispiel benutzten Lumineszenzmaterialien und sonstigen Materialien sowie die Farbkoordinaten der erhaltenen LEDs gemäß der oben beschriebenen allgemeinen Vorschrift sind in Tabelle 1 zusammengefasst. Die zugehörigen LED-Spektren sind in Figur 8 dargestellt.

Tabelle 1: Zusammensetzung und Eigenschaften der hergestellten LED A und LED B.

| Parameter | LED A (2700 K) mit Leuchtstoff aus Beispiel 2: | LED B (3000 K) mit Leuchtstoff aus Beispiel 2: |
|---|---|---|
| $m_{LS}$ / g | 8,43 | 6,84 |
| m (YAG: Ce) | 0,71 | 0,71 |
| $c_{YAG:Ce}$ / Gew.-% | 5,56 | 5,56 |
| $m_{Silikon}$ | 4,46 | 4,41 |
| $c_{LS}$ / Gew.-% | 61,9 | 57,2 |
| CIE 1931 x | 0,403 | 0,4338 |
| CIE 1931 y | 0,410 | 0,4578 |

**Beschreibung der Figuren**

Figur 1: Reflexionsspektrum von $HK_3W_{0,99}Mn_{0,01}F_{6,02}O_{1,98}$ (Beispiel 2).

Figur 2: Anregungsspektrum von $HK_3W_{0,99}Mn_{0,01}F_{6,02}O_{1,98}$ (Beispiel 2) ($\lambda_{Em}$ = 627 nm) .

Figur 3: Emissionsspektrum von $HK_3W_{0,99}Mn_{0,01}F_{6,02}O_{1,98}$ (Beispiel 2) ($\lambda_{Ex}$ = 465 nm) .

Figur 4: Thermische Löschkurve von $HK_3W_{0,99}Mn_{0,01}F_{6,02}O_{1,98}$ (Beispiel 2) ($\lambda_{Ex}$ = 465 nm) .

Figur 5: Röntgenpulverdiffraktogramm von $HK_3Mo_{0,99}Mn_{0,01}F_{6,02}O_{1,98}$ (Beispiel 1)

Figur 6: Röntgenpulverdiffraktogramm von $HK_3W_{0,99}Mn_{0,01}F_{6,02}O_{1,98}$ (Beispiel 2)

Figur 7: Darstellung der Kristallstruktur von $HK_3WF_6O_2$:Mn (Beispiel 2)

Figur 8: Emissionsspektrum der LED A (gestrichelte Linie) enthaltend YAG:Ce und $HK_3W_{0,99}Mn_{0,01}F_{6,02}O_{1,98}$ (Beispiel 2) für die Farbtemperatur 2700 K und Emissionsspektrum der LED B (durchgezogene Linie) enthaltend YAG:Ce und $HK_3W_{0,99}Mn_{0,01}F_{6,02}O_{1,98}$ (Beispiel 2) für die Farbtemperatur 3000 K.

**Patentansprüche**

1. Lichtquelle, umfassend:

- eine Primärlichtquelle zur Emission von primärer Strahlung; und
- ein Lumineszenzmaterial oder eine strahlungskonvertierende Mischung mit dem Lumineszenzmaterial zur Konversion der primären Strahlung in eine längerwellige Strahlung, wobei das Lumineszenzmaterial auf einem Oxidohalogenid-Wirtsgitter basiert sowie ein Absorptionsmaximum zwischen 425 nm und 500 nm und Emissionsmaxima im Bereich zwischen 610 nm und 640 nm aufweist, wobei eine mittlere Partikelgröße des Lumineszenzmaterials zwischen 50 nm und 30 $\mu$m beträgt, und wobei das Lumineszenzmaterial durch die allgemeine Formel (I) dargestellt ist:

$$(A_{4-a}B_a)_{m/2+n/2}X_{2m}[MX_4O_2]_n \qquad (I),$$

und mit Mn(IV) dotiert ist, wobei für die verwendeten Symbole und Indizes gilt:

A ist ausgewählt aus der Gruppe bestehend aus H und D und Mischungen davon, wobei D Deuterium ist;
B ist ausgewählt aus der Gruppe bestehend aus Li, Na, K, Rb, Cs, $NH_4$, $ND_4$, $NR_4$ und Mischungen aus zwei oder mehreren davon, wobei R ein Alkyl- oder Arylrest ist;
X ist ausgewählt aus der Gruppe bestehend aus F und Cl und Mischungen davon;
M ist ausgewählt aus der Gruppe bestehend aus Cr, Mo, W, Re und Mischungen aus zwei oder mehreren davon;

$0 \leq a \leq 4$; $0 < m \leq 10$; und $1 \leq n \leq 10$.

2. Lichtquelle nach Anspruch 1, **dadurch gekennzeichnet, dass** ein Emissionsmaximum der Primärlichtquelle im Bereich von 250 nm bis 550 nm liegt.

3. Lichtquelle nach Anspruch 1 oder 2, **dadurch gekennzeichnet, dass** die strahlungskonvertierende Mischung weitere Konversionsleuchtstoffe mit anderen Fluoreszenzfarben umfasst.

4. Lichtquelle nach einem der Ansprüche 1 bis 3, **dadurch gekennzeichnet, dass** das Lumineszenzmaterial CIE1931-Farbkoordinaten $x > 0,66$ und $y < 0,33$ aufweist.

5. Lichtquelle nach einem der Ansprüche 1 bis 4, **dadurch gekennzeichnet, dass** das Lumineszenzmaterial ein Lumenäquivalent aufweist, welches höher als 200 lm/W ist.

6. Lichtquelle nach einem der Ansprüche 1 bis 5, **dadurch gekennzeichnet, dass** sie zur Realisierung von warmweißem Licht mit einer korrelierten Farbtemperatur von weniger als 4000 K ausgebildet ist.

7. Lichtquelle nach einem der Ansprüche 1 bis 6, **dadurch gekennzeichnet, dass** das Lumineszenzmaterial durch die allgemeine Formel (II) dargestellt ist:

$$(A_{4-a}B_a)_{m/2+n/2}X_{2m}[M_{1-x}X_{4+2x}O_{2-2x}]_n{:}[Mn(IV)_x]_n \qquad (II)$$

wobei A, B, X, M, a, m und n wie in Anspruch 1 definiert sind und für x gilt: $0 < x < 1,0$.

8. Lichtquelle nach einem der Ansprüche 1 bis 7, **dadurch gekennzeichnet, dass** das Lumineszenzmaterial durch die allgemeine Formel (III) dargestellt ist:

$$AB_3M_{1-x}X_{6+2x}O_{2-2x}{:}Mn(IV)_x \qquad (III),$$

wobei A, B, M und X wie in Anspruch 1 definiert sind und für x gilt: $0 < x < 1,0$.

**Claims**

1. Light source, comprising:

- a primary light source for emitting primary radiation; and
- a luminescent material or a radiation-converting mixture with the luminescent material for converting the primary radiation into longer-wave radiation, the luminescent material being based on an oxidohalide host lattice and having an absorption maximum between 425 nm and 500 nm and emission maxima in the range between 610 nm and 640 nm, wherein an average particle size of the luminescent material is between 50 nm and 30 um, and wherein the luminescent material is represented by the general formula (I):

$$(A_{4-a}B_a)_{m/2+n/2}X_{2m}[MX_4O_2]_n \qquad (I),$$

and doped with Mn(IV), wherein the used symbols and indices are as follows:

A is selected from the group consisting of H and D and mixtures thereof, wherein D is deuterium;
B is selected from the group consisting of Li, Na, K, Rb, Cs, $NH_4$, $ND_4$, $NR_4$ and mixtures of two or more thereof, wherein R is an alkyl or aryl radical;
X is selected from the group consisting of F and Cl and mixtures thereof;
M is selected from the group consisting of Cr, Mo, W, Re and mixtures of two or more thereof;

$0 \leq a \leq 4$; $0 < m \leq 10$; and $1 \leq n \leq 10$.

2.  Light source according to claim 1, **characterized in that** an emission maximum of the primary light source is in the range from 250 nm to 550 nm.

3.  Light source according to claim 1 or 2, **characterized in that** the radiation-converting mixture comprises further conversion phosphors with other fluorescent colours.

4.  Light source according to one of the claims 1 to 3, **characterized in that** the luminescent material shows CIE1931 colour coordinates of x > 0.66 and y < 0.33.

5.  Light source according to one of the claims 1 to 4, **characterized in that** the luminescent material shows a lumen equivalent, which is higher than 200 lm/W.

6.  Light source according to one of the claims 1 to 5, **characterized in that** it is configured for realising warm white light having a correlated colour temperature of less than 4000 K.

7.  Light source according to one of the claims 1 to 6, **characterized in that** the luminescent material is represented by the general formula (II):

$$(A_{4-a}B_a)_{m/2+n/2}X_{2m}[M_{1-x}X_{4+2x}O_{2-2x}]_n{:}[Mn(IV)_x]_n \qquad (II)$$

wherein A, B, X, M, a, m and n are defined as in claim 1 and for x is: 0 < x < 1.0.

8.  Light source according to one of the claims 1 to 7, **characterized in that** the luminescent material is represented by the general formula (III):

$$AB_3M_{1-x}X_{6+2x}O_{2-2x}{:}Mn(IV)_x \qquad (III),$$

wherein A, B, M and X are defined as in claim 1 and for x is: 0 < x < 1.0.

**Revendications**

1.  Source lumineuse, comprenant:

- une source de lumière primaire pour émettre un rayonnement primaire; et
- un matériau luminescent ou un mélange convertissant le rayonnement avec le matériau luminescent en vue d'une conversion du rayonnement primaire en rayonnement de longueur d'onde plus longue, dans laquelle le matériau luminescent présente sur la base d'un réseau hôte à un halogénure d'oxyde tant un maximum d'absorption compris entre 425 nm et 500 nm que des maxima d'émission dans la plage comprise entre 610 nm et 640 nm, dans laquelle une taille moyenne des particules du matériau luminescent est comprise entre 50 nm et 30 $\mu$m, et le matériau luminescent est représenté par la formule générale (I):

$$(A_{4-a}B_a)_{m/2+n/2}X_{2m}[MX_4O_2]_n \qquad (I),$$

et est dopé au Mn (IV), dans laquelle pour les symboles et indices vaut ce qui suit:

A est choisi dans le groupe constitué de H et D et de leurs mélanges, où D représente le deutérium;
B est choisi dans le groupe constitué de Li, Na, K, Rb, Cs, $NH_4$, $ND_4$, $NR_4$ et des mélanges de deux ou plusieurs de ceux-ci, dans laquelle R est un alkyle ou un aryle résiduel;

X est choisi dans le groupe composé de F et C1 et leurs mélanges;

M est choisi dans le groupe constitué de Cr, Mo, W, Re et des mélanges de deux ou plusieurs de ceux-ci;

$0 \leq a \leq 4$; $0 \leq m \leq 10$; et $1 \leq n \leq 10$.

2. Source lumineuse selon la revendication 1, **caractérisée en ce qu'**un maximum d'émission de la source lumineuse primaire est compris entre 250 nm et 550 nm.

3. Source lumineuse selon la revendication 1 ou 2, **caractérisée en ce que** le mélange convertissant le rayonnement comprend des phosphores de conversion supplémentaires avec d'autres couleurs fluorescentes.

4. Source lumineuse selon une des revendications 1 à 3, **caractérisée en ce que** le matériau luminescent présente des coordonnées de couleur CIE1931 x > 0,66 et y < 0,33.

5. Source lumineuse selon une des revendications 1 à 4, **caractérisée en ce que** le matériau luminescent présente un équivalent lumen supérieur à 200 1m/W.

6. Source lumineuse selon une des revendications 1 à 5, **caractérisée en ce qu'**elle est utilisée pour produire une lumière blanche chaude avec une température de couleur corrélée inférieure à 4000 K.

7. Source lumineuse selon une des revendications 1 à 6, **caractérisée en ce que** le matériau luminescent est représenté par la formule générale (II):

$$(A_{4-a}B_a)_{m/2+n/2}X_{2m}[M_{1-x}X_{4+2x}O_{2-2x}]_n:[Mn(IV)_x]_n \qquad (II),$$

dans laquelle A, B, X, M, a, m et n sont tels que définis dans la revendication 1 et pour x: $0 < x < 1,0$.

8. Source lumineuse selon une des revendications 1 à 7, **caractérisée en ce que** le matériau luminescent est représenté par la formule générale (III):

$$AB_3M_{1-x}X_{6+2x}O_{2-2x}:Mn(IV)_x \qquad (III),$$

dans laquelle A, B, M et X sont tels que définis dans la revendication 1 et pour x: $0 < x < 1,0$.

Fig. 1

Fig. 2

Fig. 3

Fig. 4

Fig. 5

Fig. 6

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2014152787 A1
- WO 2008100517 A1
- CN 106800930 A
- CN 107043624 A
- JP 4304290 A
- WO 9110715 A
- WO 9927033 A
- US 20070298250 A
- WO 2009065480 A
- WO 2010075908 A
- WO 2005075339 A
- WO 2006134599 A
- EP 2528989 B1
- US 8062421 B2
- WO 2017041875 A1
- US 20140369036 A1

**In der Beschreibung aufgeführte Nicht-Patentliteratur**

- *Japanese Journal of Applied Physics,* 2005, vol. 44 (21), L649-L651